# EUROPEAN PATENT APPLICATION

(11) **EP 4 657 201 A1**
(43) Date of publication of application: **03.12.2025**
(21) Application number: 25177278.6
(22) Date of filing: 19.05.2025
(51) Int. Cl.: G06F 1/16, H04M 1/02

(54) **DISPLAY DEVICE AND ELECTRONIC DEVICE**

(30) Priority: 27.05.2024 KR 20240068313
(71) Applicant: Samsung Display Co., Ltd., Yongin-si, Gyeonggi-do 17113 (KR)
(72) Inventor: CHOI, Yeol, 17113 Giheung-gu, Yongin-si, Gyeonggi-do (KR); PARK, Soonryong, 17113 Giheung-gu, Yongin-si, Gyeonggi-do (KR); LEE, Kyu-Taek, 17113 Giheung-gu, Yongin-si, Gyeonggi-do (KR); SIM, Yong-Kyun, 17113 Giheung-gu, Yongin-si, Gyeonggi-do (KR); JEONG, Jae Hoon, 17113 Giheung-gu, Yongin-si, Gyeonggi-do (KR); KIM, Dongho, 17113 Giheung-gu, Yongin-si, Gyeonggi-do (KR); HEO, Jinnyoung, 17113 Giheung-gu, Yongin-si, Gyeonggi-do (KR); CHO, Hyun-Il, 17113 Giheung-gu, Yongin-si, Gyeonggi-do (KR)
(74) Representative: Dr. Weitzel & Partner

(57) **Abstract**

A display device includes a display module including folding and non-folding display portions, and a window including an upper surface which is flat and apart from the display module, and a lower surface which is flat, faces the upper surface, and is adjacent to the display module. The window includes a base glass including a base upper surface which is flat and is apart from the display module, a base lower surface facing the base upper surface with a groove portion defined therein and corresponding to the folding display portion, and a base side surface disposed between the base upper and lower surfaces, and a resin layer including a folding resin portion below the base glass to correspond to the folding display portion, a non-folding resin portion below the base glass to correspond to the non-folding display portion, and a side resin portion covering the base side surface.

## Description

The invention relates to a display device and an electronic device, and more particularly, to a display device and an electronic device that include a window at the uppermost portion thereof and are foldable.

Various types of electronic devices are used to provide image information, and recently, flexible display devices capable of being folded or bent and electronic devices including the flexible display devices are being developed. Unlike rigid electronic devices, flexible electronic devices can change their shapes in various ways, such as being folded, rolled, or bent, and thus the flexible electronic devices have the characteristics of being portable regardless of the size of a screen.

### SUMMARY

A flexible display device or electronic device may include a window to protect a display panel, etc. without impeding folding or bending operations. Accordingly, it may be desired to develop a window having high durability while maintaining desirable folding characteristics.

The invention provides a display device having a reduced overall thickness and excellent durability and surface quality.

The invention also provides a display device with improved processability and economic feasibility and high durability and folding characteristics by simplifying process steps in a way of omitting members which may be additionally provided on a window.

The invention also provides an electronic device having a reduced overall thickness and high durability and strength characteristics.

The invention is defined by the independent claims. Preferred embodiments are disclosed in the dependent claims and the description.

An embodiment of the invention provides a display device including a display module including a folding display portion, which is transformed into a folded or non-folded state, and a non-folding display portion adjacent to the folding display portion, and a window including an upper surface which is a flat surface and is spaced apart from the display module, and a lower surface which is a flat surface, faces the upper surface of the window, and is adjacent to the display module, where the window includes a base glass including a base upper surface which is a flat surface and is spaced apart from the display module, a base lower surface facing the base upper surface and having a groove portion defined therein to correspond to the folding display portion, and a base side surface disposed between the base upper surface and the base lower surface, and a resin layer which includes a folding resin portion disposed below the base glass to correspond to the folding display portion, a non-folding resin portion disposed below the base glass to correspond to the non-folding display portion, and a side resin portion covering at least a portion of the base side surface, where a thickness of a portion of the base glass overlapping the non-folding display portion is about 70 micrometers (µm) or greater, a maximum thickness of the folding resin portion is about 30 *µ* m or greater, and a width of the side resin portion is in a range of about 50 µm to about 300 µm.

In an embodiment, the thickness of the portion of the base glass overlapping the non-folding display portion may be in a range of about 150 µm to about 300 *µ* m.

In an embodiment, the maximum thickness of the folding resin portion may be in a range of about 100 *µ* m to about 300 *µ* m.

In an embodiment, a thickness from a lowermost surface of the display module to an uppermost surface of the window may be about 700 µm or less.

In an embodiment, the display module may include a display panel and a support plate disposed below the display panel.

In an embodiment, the base glass may be divided into a folding portion including the groove portion, and a first non-folding portion and a second non-folding portion spaced apart from each other with the folding portion interposed therebetween, where the folding portion may have a thickness in a range of about 30 *µ* m to about 80 *µ*m.

In an embodiment, an upper surface of the window, which is the uppermost surface of the window, may be an uppermost surface of the display device.

In an embodiment, the upper surface of the window may be defined by the base upper surface and an upper surface of the side resin portion.

In an embodiment, the window may further include a functional layer disposed on the base glass, where the functional layer may include a reflection reduction layer having a reflectance of about 2% or less at a wavelength of about 550 nanometers (nm) and an anti-fingerprint layer disposed on the reflection reduction layer and having a water contact angle of about 100 degrees or greater, where an upper surface of the functional layer may be an uppermost surface of the display device.

In an embodiment, a thickness of the reflection reduction layer may be in a range of about 50 nm to about 1000 nm, a thickness of the anti-fingerprint layer may be in a range of about 5 nm to about 50 nm, and a thickness from a lowermost surface of the display module to an upper surface of the anti-fingerprint layer may be about 700 µm or less.

In an embodiment, the functional layer may overlap the base glass and the side resin portion, and the functional layer may be disposed directly on the base upper surface and an upper surface of the side resin portion.

In an embodiment, the resin layer may include a urethane-based resin and a silane-based additive.

In an embodiment, the resin layer may have a modulus of about 50 megapascals (MPa) or greater at about 25°C, a modulus of about 1000 MPa or less at about -20°C, and a modulus of about 500 MPa or less at about 60°C.

In an embodiment, the display module may include a display region and a non-display region surrounding the display region and may further include a printed layer overlapping the non-display region, where the printed layer may be disposed directly between the base glass and the resin layer, directly on the lower surface of the resin layer between the window and the display module, or directly on the upper surface of the display module between the window and the display module.

In an embodiment of the invention, a display device includes a display module including a folding display portion, which is transformed into a folded or non-folded state, and a non-folding display portion adjacent to the folding display portion, and a window including an upper surface which is a flat surface and is spaced apart from the display module, and a lower surface which is a flat surface, faces the upper surface of the window, and is adjacent to the display module, where the window includes: a base glass including a base upper surface which is a flat surface and is spaced apart from the display module, a base lower surface which faces the base upper surface and has a groove portion defined therein to correspond to the folding display portion, and a base side surface disposed between the base upper surface and the base lower surface; a resin layer including a folding resin portion disposed below the base glass to correspond to the folding display portion, a non-folding resin portion disposed below the base glass to correspond to the non-folding display portion, and a side resin portion covering at least a portion of a side surface of the base glass; and a functional layer overlapping the base upper surface and an upper surface of the side resin portion, disposed directly on the base glass, where the functional layer includes at least one selected from a reflection reduction layer or an anti-fingerprint layer, where the upper surface of the window is an uppermost surface exposed to an outside.

In an embodiment, the resin layer may have a modulus of about 50 MPa or greater at about 25°C, a modulus of about 1000 MPa or less at about -20°C, and a modulus of about 500 MPa or less at about 60°C.

In an embodiment, the resin layer may include a urethane-based resin and a silane-based additive.

In an embodiment, the thickness of the reflection reduction layer may be in a range of about 50 nm to about 1000 nm, and the thickness of the anti-fingerprint layer may be in a range of about 5 nm to about 50 nm.

In an embodiment, the window may further include a primer layer disposed directly on the lower surface of the functional layer.

In an embodiment, a thickness of the primer layer may be about 5 µm or less.

In an embodiment, the primer layer may include at least one selected from an epoxy-based resin, an amino-based resin, a mercapto-based resin, or methoxy silane.

In an embodiment, a thickness of a portion of the base glass overlapping the non-folding display portion may be about 70 µm or greater.

In an embodiment, a maximum thickness of the folding resin portion may be about 30 µm or greater.

In an embodiment, a thickness from a lowermost surface of the display module to an upper surface of the functional layer may be about 700 µm or less.

In an embodiment of the invention, a display device includes: a display panel; a support plate including a folding support portion disposed below the display panel with a plurality of openings defined therein and a first non-folding support portion and a second non-folding support portion spaced apart from each other in a first direction with the folding support portion interposed therebetween; and a window disposed above the display panel and including a base glass, where the base glass includes a first surface which is a flat surface and is spaced apart from the display module, and a second surface which faces the first surface and has a groove portion defined therein to correspond to the folding support portion, and a resin layer covering the second surface and a side surface of the base glass, where an entire portion of the folding support portion overlaps the groove portion, and a width of the groove portion in the first direction is greater than the width of the folding support portion in the first direction.

In an embodiment, the base glass may include a folding portion including the groove portion, and a first non-folding portion and a second non-folding portion which are spaced apart from each other in the first direction with the folding portion interposed therebetween, and each of at least a portion of the first non-folding support portion and at least a portion of the second non-folding support portion may overlap the folding portion.

In an embodiment, the width of the groove portion in the first direction may be in a range of about 7 millimeters (mm) to about 50 mm, and the width of the folding support portion in the first direction may be in a range of about 5 mm to about 20 mm.

In an embodiment, the groove portion may be defined by a slimming upper portion which is a flat surface and faces the first surface, a first diagonal surface extending from the slimming upper portion to the second surface of the first non-folding portion, and a second diagonal surface extending from the slimming upper portion to the second surface of the second non-folding portion, where a width of the slimming upper portion in the first direction may be in a range of about 1 mm to about 30 mm, and each of a width of the first diagonal surface in the first direction and a width of the second diagonal surface in the first direction may be in a range of about 3 mm to about 15 mm.

In an embodiment, the folding portion may have a thickness in a range of about 30 *µ* m to about 80 *µ* m, and each of the first non-folding portion and the second non-folding portion may have a thickness in a range of about 70 *µ* m to about 300 *µ* m.

In an embodiment, a maximum thickness of the resin layer overlapping the folding portion may be in a range of about 30 *µ* m to about 300 *µ* m.

In an embodiment of the invention, a display device includes: a display module divided into a folding portion, which is transformed into a folded or non-folded state, and a non-folding portion adjacent to the folding portion, where the display module includes a display panel and a support plate disposed below the display panel; a base glass including a base upper surface which is a flat surface and is spaced apart from the display module, a base lower surface having a concave groove portion defined therein in a direction toward the base upper surface to correspond to the folding portion, and a base side surface connecting the base upper surface and the base lower surface to each other; a resin layer which fills the groove portion and cover the base lower surface and the base side surface; and a sealing portion disposed on side surfaces of the display module and the resin layer, where an edge of the display panel and an edge of the resin layer overlap each other in a plan view.

In an embodiment, a width of the sealing portion may be in a range of about 100 *µ* m to about 300 *µ* m.

In an embodiment, in the plan view, the sealing portion may entirely surround the edge of the display module and the edge of the resin layer.

In an embodiment, an upper surface of the display device may be defined by the base upper surface, an upper surface of the resin layer covering the base side surface, and an upper surface of the sealing portion surrounding the resin layer.

In an embodiment, an upper surface of the sealing portion protrude more outwardly than the base upper surface and the upper surface of the resin layer in the plan view, where a thickness of a protruding portion of the sealing portion may be about 30 µm or less.

In an embodiment, the sealing portion may include a black coloring agent, and an optical density (OD) of the sealing portion may be about 2 or greater.

In an embodiment of the invention, a display device includes: a display module including a folding display portion, which is transformed into a folded or non-folded state, and a non-folding display portion adjacent to the folding display portion; and a window including a window upper surface which is a flat surface and is spaced apart from the display module, and a window lower surface which is a flat surface, faces the window upper surface, and is adjacent to the display module, where the window includes: a base glass including a base upper surface spaced apart from the display module and a base lower surface facing the base upper surface and having a groove portion defined on the base upper surface or the base lower surface to correspond to the folding display portion; and a resin layer which fills the groove portion of the base glass and disposed on the base upper surface or the base lower surface, where a thickness of the base glass in a portion excluding the groove portion is about 300 µm or less, and the resin layer has a modulus of about 50 MPa or greater at about 25° C, a modulus of about 1000 MPa or less at about -20°C, and a modulus of about 500 MPa or less at about 60°C.

In an embodiment, the resin layer may have a modulus in a range of about 50 MPa to about 1000 MPa at about 25°C, a modulus in a range of about 100 MPa to about 1000 MPa at about -20°C, and a modulus in a range of about 10 MPa to about 500 MPa at about 60°C.

In an embodiment, the resin layer may be disposed directly on the base lower surface, and the resin layer may include a urethane-based resin and a silane-based additive.

In an embodiment, the resin layer may be disposed directly on the base lower surface, and the window may further include a functional layer disposed on the base upper surface, where the functional layer may include at least one selected from a reflection reduction layer or an anti-fingerprint layer, where the reflection reduction layer may have a thickness in a range of about 50 nm to about 1000 nm, and the anti-fingerprint layer may have a thickness in a range of about 5 nm to about 50 nm.

In an embodiment, the resin layer may be disposed directly on the base lower surface, and the window may further include: a functional layer disposed on the base upper surface a; and a primer layer disposed on the lower surface of the functional layer, where the functional layer may include at least one selected from a reflection reduction layer or an anti-fingerprint layer, a thickness of the primer layer may be about 5 µm or less, and the primer layer may include at least one selected from an epoxy-based resin, an amino-based resin, a mercapto-based resin, or methoxy silane.

In an embodiment of the invention, an electronic device includes: a display module divided into a folding portion, which is transformed into a folded or non-folded state, and a non-folding portion adjacent to the folding portion, where the display module includes a display panel and a support plate disposed below the display panel; a window disposed on the display module and including a base glass and a resin layer overlapping an entire portion of the base glass; a housing accommodating the display module and the window; and a sealing portion which fills a space between the housing and the display module and a space between the housing and the window, where the base glass includes a base upper surface that is spaced apart from the display module and is a flat surface, a base lower surface having a concave groove portion defined therein in the direction of the base upper surface to correspond to the folding display portion, and a base side surface connecting the base upper surface and the base lower surface to each other; the resin layer fills the groove portion and covers the base lower surface and the base side surface; and the sealing portion is disposed directly on a side surface of the resin layer.

In an embodiment, in a plan view, the sealing portion may have a shape surrounding an entire exterior of the window.

In an embodiment, in a plan view, a width of the sealing portion may be in a range of about 100 *µ* m to about 300 µm.

In an embodiment, the sealing portion may be an adhesive layer which couples the housing and the display module to each other and the housing and the window to each other.

In an embodiment, an upper surface of the electronic device may be defined by the base upper surface, an upper surface of the resin layer covering the base side surface, and an upper surface of the sealing portion surrounding the resin layer.

In an embodiment, an upper surface of the sealing portion may protrude more outwardly than the base upper surface and the upper surface of the resin layer in a plan view, and a thickness of the protruding portion of the sealing portion may be about 30 µm or less.

In an embodiment, the window may further include a functional layer disposed to overlap the base upper surface and the upper surface of the resin layer, where the functional layer may include at least one selected from a reflection reduction layer or an anti-fingerprint layer.

In an embodiment, the display module may include a display region, a non-display region surrounding the outside of the display region, a non-display bending portion disposed at one side of the non-display region and bent toward the lower side of the display module, and a bending protection layer disposed on the non-display bending portion, where the sealing portion may cover the bending protection layer.

In an embodiment, the resin layer may include a urethane-based resin and a silane-based additive.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain principles of the invention. In the drawings:
FIG. 1A is a perspective view illustrating an electronic device in an unfolded state according to an embodiment of the invention;
FIG. 1B is a perspective view illustrating an inner-folding process of the electronic device according to an embodiment of the invention which is illustrated in FIG. 1A;
FIG. 1C is a perspective view illustrating an outer-folding process of the electronic device according to an embodiment of the invention which is illustrated in FIG. 1A;
FIG. 2A is a perspective view illustrating an electronic device in an unfolded state according to an embodiment of the invention;
FIG. 2B is a perspective view illustrating an inner-folding process of the electronic device according to an embodiment of the invention which is illustrated in FIG. 2A;
FIG. 2C is a perspective view illustrating an outer-folding process of the electronic device according to an embodiment of the invention which is illustrated in FIG. 2A;
FIG. 3A is a perspective view of an electronic device according to an embodiment of the invention;
FIGS. 3B and 3C are perspective views illustrating the electronic device illustrated in FIG. 3A in a multi-folded state;
FIG. 4 is an exploded perspective view of an electronic device according to an embodiment of the invention;
FIG. 5 is a cross-sectional view of a display device according to an embodiment of the invention;
FIG. 6 is a perspective view of a window according to an embodiment of the invention;
FIG. 7 is a cross-sectional view of the window according to an embodiment of the invention;
FIG. 8A is a cross-sectional view illustrating a portion of the window according to an embodiment of the invention;
FIG. 8B is a cross-sectional view illustrating a portion of the window according to an embodiment of the invention;
FIG. 9 is a cross-sectional view of a display device according to an embodiment of the invention;
FIG. 10A is a cross-sectional view of a window according to an embodiment of the invention;
FIG. 10B is a cross-sectional view illustrating a portion of the window according to an embodiment of the invention;
FIG. 11 is a perspective view of a support plate according to an embodiment of the invention;
FIG. 12 is a cross-sectional view illustrating an arrangement form of the window and the support plate in the display device according to an embodiment of the invention;
FIG. 13 is a perspective view of an electronic device according to an embodiment of the invention;
FIG. 14 is an exploded perspective view of a display device according to an embodiment of the invention;
FIG. 15A is a cross-sectional view of a partial region of the display device according to an embodiment of the invention;
FIG. 15B is a cross-sectional view of a partial region of a display device according to an embodiment of the invention;
FIG. 16 is a perspective view of a partial region of the electronic device according to an embodiment of the invention;
FIG. 17 is a cross-sectional view of a partial region of the electronic device according to an embodiment of the invention;
FIG. 18 is a cross-sectional view of a partial region of a display device according to an embodiment of the invention;
FIGS. 19A to 19C are cross-sectional views illustrating steps in a method of manufacturing an electronic device according to an embodiment of the invention;
FIG. 20A is a cross-sectional view of a partial region of a display device according to an embodiment of the invention;
FIG. 20B is a cross-sectional view of a partial region of a display device according to an embodiment of the invention; and
FIG. 20C is a cross-sectional view of a partial region of a display device according to an embodiment of the invention.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

It will be understood that when an element is referred to as being "on" another element, it can be directly on the other element or intervening elements may be present therebetween. In contrast, when an element is referred to as being "directly on" another element, there are no intervening elements present.

In this specification, it will be understood that when an element (or region, layer, portion, etc.) is referred to as being "connected to" or "coupled to" another element, it can be directly connected or coupled to the other element, or intervening elements may be present.

Like reference numerals refer to like elements throughout. In addition, in the drawings, the thicknesses, ratios, and dimensions of elements are exaggerated for effective description of the technical contents.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

In the disclosure, being "directly disposed" may mean that there is no layer, film, region, plate, or the like added between a part such as a layer, film, region, or plate and another part such as a layer, film, region, or plate. For example, being "directly disposed" may mean that no additional member such as an adhesive member is disposed between two layers or two members.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, a display device according to an embodiment of the invention and an electronic device according to an embodiment of the invention will be described with reference to the accompanying drawings.

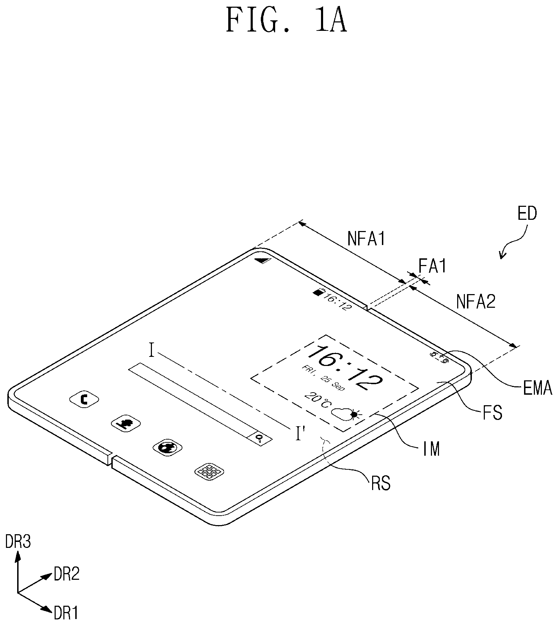

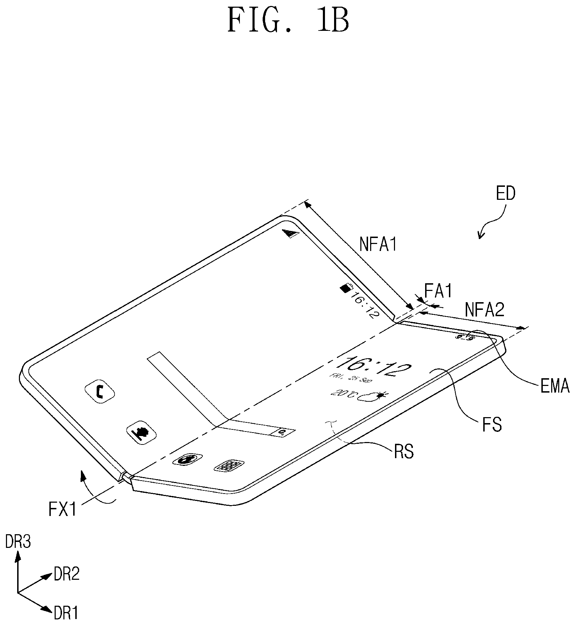

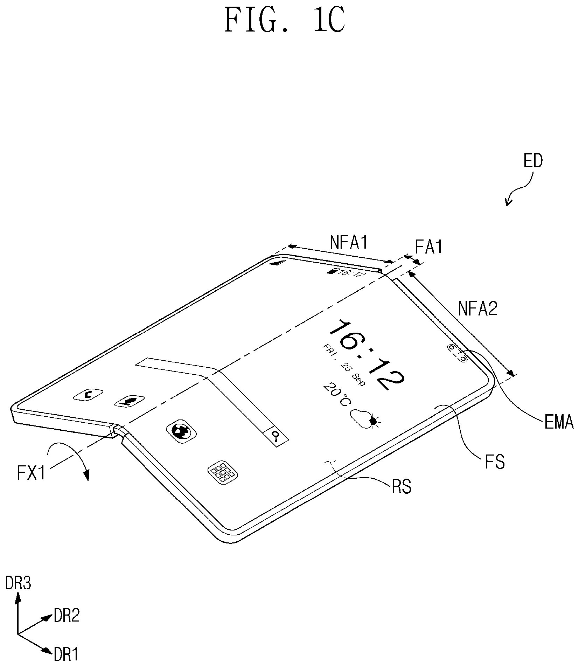

FIG. 1A is a perspective view illustrating an electronic device in an unfolded state according to an embodiment of the invention. FIG. 1B is a perspective view illustrating an inner-folding process of the electronic device according to an embodiment of the invention which is illustrated in FIG. 1A. FIG. 1C is a perspective view illustrating an outer-folding process of the electronic device according to an embodiment of the invention which is illustrated in FIG. 1A.

An electronic device ED according to an embodiment of the invention may be activated based on an electrical signal. In an embodiment, the electronic device ED may be any electronic device including a screen thereon, for example, a mobile phone, a tablet, a car navigation system, a game console, or a wearable device, but the embodiment of the invention is not limited thereto. In FIG. 1A, an embodiment where the electronic device ED is a mobile phone is illustrated as an example, but not being limited thereto.

As shown in FIGS. 1A to 1C, the electronic device ED according to an embodiment of the invention may include a first display surface FS defined by a first direction axis DR1 and a second direction axis DR2 crossing the first direction axis DR1. The electronic device ED may provide an image IM to a user through the first display surface FS. The electronic device ED according to an embodiment of the invention may display an image IM toward a third direction axis DR3 on the first display surface FS parallel to each of the first and second direction axes DR1 and DR2. In this specification, the front (or upper) and rear (or lower) surfaces of each component are defined based on a direction in which the image IM is displayed. The front and rear surfaces are opposed to each other in the third direction axis DR3, and the normal direction of each of the front and rear surfaces may be parallel to the third direction axis DR3. A direction of the third direction axis DR3 may be a thickness direction of the electronic device ED.

The electronic device ED according to an embodiment of the invention may include a first display surface FS and a second display surface RS. The first display surface FS may include an electronic module region EMA. The second display surface RS may be defined as a surface opposed to at least a portion of the first display surface FS. That is, the second display surface RS may be defined as a portion of the rear surface of the electronic device ED.

The electronic device ED according to an embodiment of the invention may sense an external input applied from the outside. The external input may include various types of inputs provided from the outside of the electronic device ED. In an embodiment, for example, the external input may include not only a touch by a part of a user's body, such as the user's hand, but also an external input (e.g., hovering) applied in proximity to the electronic device ED or adjacent to the electronic device ED at a predetermined distance. In addition, the external input may have various forms such as force, pressure, temperature, and light.

In the drawings, the first to third direction axes DR1 to DR3 are illustrated, and directions indicated by the first to third direction axes DR1, DR2, and DR3 described in this specification are relative concepts and may be converted into other directions. In addition, the directions indicated by the first to third direction axes DR1, DR2, and DR3 may be described as first to third directions, and the same reference numerals used for the first to third direction axes (i.e., DR1, DR2, and DR3) may also be used for the first to third directions.

The first display surface FS of the electronic device ED may include an active region which is activated according to an electrical signal. The electronic device ED according to an embodiment of the invention may display an image IM through the first display surface FS. In addition, various types of external inputs may be sensed on the first display surface FS.

The electronic device ED may include a folding region FA1 and non-folding regions NFA1 and NFA2. In an embodiment of the invention, the non-folding regions NFA1 and NFA2 may be disposed to be adjacent to the folding region FA1 with the folding region FA1 interposed therebetween. The electronic device ED according to an embodiment of the invention may include a first non-folding region NFA1 and a second non-folding region NFA2 disposed to be spaced apart from each other in the direction of the first direction axis DR1 with the folding region FA1 interposed therebetween. In an embodiment, for example, the first non-folding region NFA1 may be disposed on one side of the folding region FA1 along the first direction DR1, and the second non-folding region NFA2 may be disposed on the other side of the folding region FA1 along the first direction DR1.

FIGS. 1A to 1C illustrate an embodiment of the electronic device ED including a single folding region FA1, but the embodiment of the invention is not limited thereto, and a plurality of folding regions may be defined in the electronic device ED. For example, the electronic device according to an embodiment of the invention may include two or more folding regions and may also include three or more non-folding regions with each of the folding regions interposed therebetween.

Referring to FIG. 1B, the electronic device ED according to an embodiment of the invention may be foldable or folded based on a first folding axis FX1. The first folding axis FX1 is an imaginary axis extending in the direction of the second direction axis DR2, and the first folding axis FX1 may be parallel to the long side of the electronic device ED. The first folding axis FX1 may extend along the second direction axis DR2 on the first display surface FS.

The electronic device ED may be foldable or folded based on the first folding axis FX1 and be transformed into an inner-folded state in which one region of the first display surface FS overlapping the first non-folding region NFA1 and the other region thereof overlapping the second non-folding region NFA2 face each other.

In an embodiment, when the electronic device ED is in an inner-folded state, the second display surface RS may be visible to a user. The second display surface RS may further include an electronic module region EMA in which an electronic module including various components is disposed, and the second display surface RS is not limited to any one embodiment.

Referring to FIG. 1C, the electronic device ED according to an embodiment of the invention may be foldable or folded based on the first folding axis FX1 and be transformed into an outer-folded state in which one region of the second display surface RS overlapping the first non-folding region NFA1 and the other region thereof overlapping the second non-folded region NFA2 face each other.

However, the embodiment of the invention is not limited thereto, and the electronic device ED may be foldable or folded based on a plurality of folding axes such that portions of the first display surface FS and the second display surface RS may face each other, and the number of folding axes and the number of non-folding regions according thereto are not particularly limited.

Various electronic modules may be disposed in the electronic module region EMA. In an embodiment, for example, the electronic module may include at least any one of a camera, a speaker, a light sensor, or a heat sensor. The electronic module region EMA may sense an external object received through the first or second display surface FS or RS or provide the outside with a sound signal such as voice through the first or second display surface FS or RS. The electronic module may include a plurality of components and is not limited to any one embodiment.

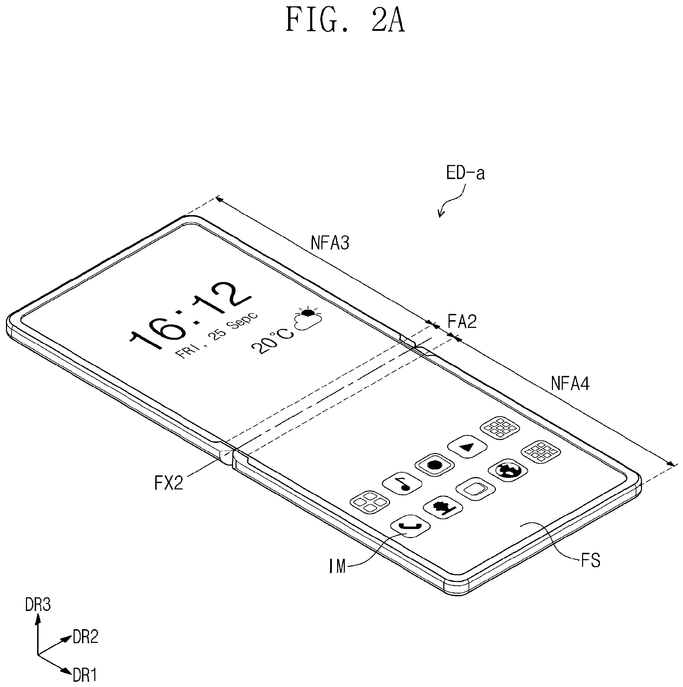

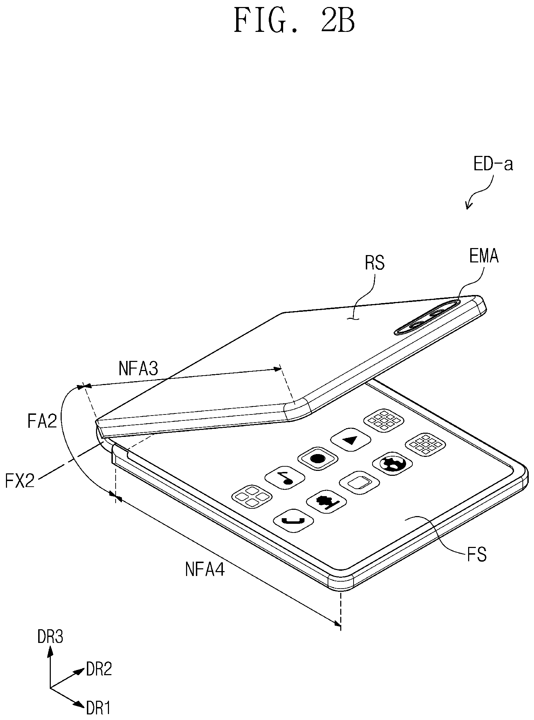

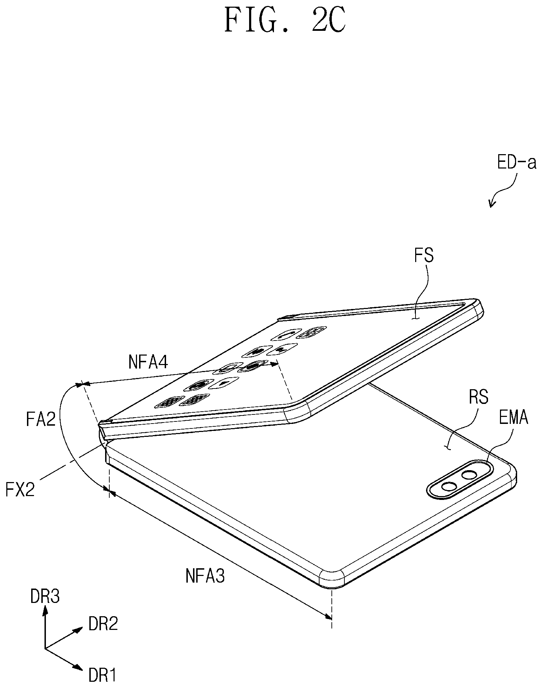

FIG. 2A is a perspective view illustrating an electronic device in an unfolded state according to an embodiment of the invention. FIG. 2B is a perspective view illustrating an inner-folding process of the electronic device according to an embodiment of the invention which is illustrated in FIG. 2A. FIG. 2C is a perspective view illustrating an outer-folding process of the electronic device according to an embodiment of the invention which is illustrated in FIG. 2A.

An electronic device ED-a according to an embodiment of the invention may be foldable or folded based on a second folding axis FX2 extending in one direction parallel to the second direction axis DR2. FIG. 2B illustrates a case in which the extension direction of the second folding axis FX2 is parallel to the extension direction of the short side of the electronic device ED-a. However, the embodiment of the invention is not limited thereto.

The electronic device ED-a according to an embodiment of the invention may include at least one folding region FA2 and non-folding regions NFA3 and NFA4 adjacent to the folding region FA2. The non-folding regions NFA3 and NFA4 may be disposed to be spaced apart from each other with the folding region FA2 interposed therebetween.

The folding region FA2 has a predetermined curvature and a predetermined curvature radius (or a radius of curvature). In an embodiment of the invention, the first non-folding region NFA3 and the second non-folding region NFA4 may face each other, and the electronic device ED-a may be inner-folded such that the first display surface FS is not exposed to the outside. In addition, referring to FIG. 2C, in an embodiment of the invention, the electronic device ED-a may be outer-folded such that the first display surface FS is exposed to the outside.

The electronic device ED-a according to an embodiment of the invention may include a second display surface RS, and the second display surface RS may be defined as a surface opposed to at least a portion of the first display surface FS. The second display surface RS may include an electronic module region EMA in which an electronic module including various components is disposed. In addition, an image or video may be displayed on at least a portion of the second display surface RS.

In an embodiment of the invention, when the electronic device ED-a is in an unfolded state, the first display surface FS may be visible to a user, and when the electronic device ED-a is in an inner-folded state, the second display surface RS may be visible to a user.

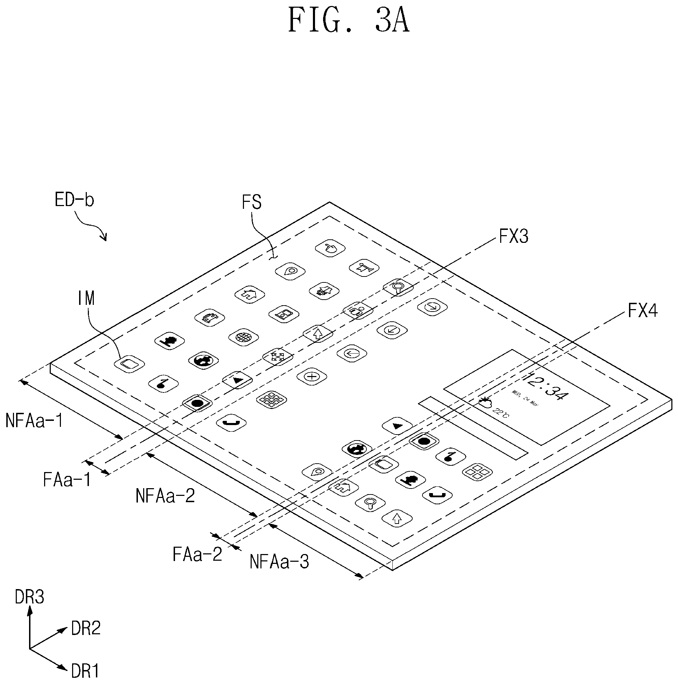

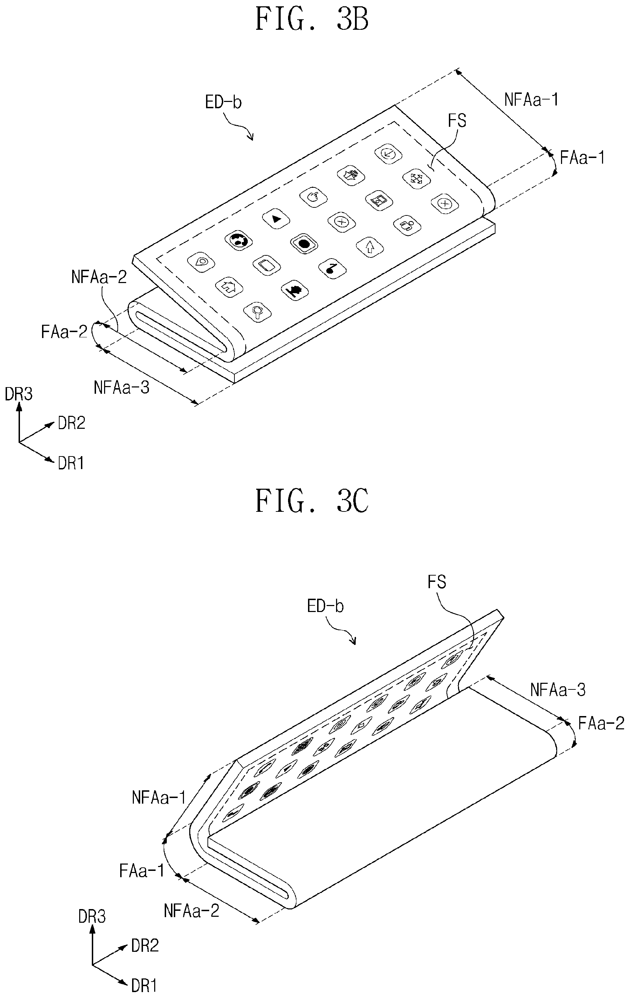

FIG. 3A is a perspective view of an electronic device ED-b according to an embodiment of the invention. FIGS. 3B and 3C are perspective views illustrating the electronic device ED-b illustrated in FIG. 3A in a multi-folded state.

Referring to FIGS. 3A to 3C, the electronic device ED-b according to an embodiment of the invention may be a multi-foldable device including a plurality of folding regions. The electronic device ED-b may include a plurality of folding regions FAa-1 and FAa-2 and a plurality of non-folding regions NFAa-1, NFAa-2, and NFAa-3. The electronic device ED-b according to an embodiment of the invention may include a first folding region FAa-1, a second folding region FAa-2, a first non-folding region NFAa-1, a second non-folding region NFAa-2, and a third non-folding region NFAa-3. In the first direction DR1, the first folding region FAa-1 is disposed between the first non-folding region NFAa-1 and the second non-folding region NFAa-2, and the second folding region FAa-2 is disposed between the second non-folding region NFAa-2 and the third non-folding region NFAa-3. FIGS. 3A to 3C illustrate an embodiment where two folding regions FAa-1 and FAa-2 and three non-folding regions NFAa-1, NFAa-2, and NFAa-3 are defined therein as an example, but the number of folding regions FAa-1 and FAa-2 and non-folding regions NFAa-1, NFAa-2, and NFAa-3 is not limited thereto and may be further increased.

Referring to FIGS. 3A and 3B, the first folding region FAa-1 may be foldable or folded based on a third folding axis FX3 parallel to the second direction DR2. The first folding region FAa-1 may be outer-folded such that the rear surface of the second non-folding region NFAa-2 and the rear surface of the first non-folding region NFAa-1 face each other and the display surface of the first non-folding region NFAa-1 faces the outside. The second folding region FAa-2 may be foldable or folded based on a fourth folding axis FX4 parallel to the second direction DR2. The second folding region FAa-2 may be inner-folded such that the display surface of the second non-folding region NFAa-2 and the display surface of the third non-folding region NFAa-3 face each other.

Referring to FIGS. 3A and 3C, the second folding region FAa-2 may be foldable or folded based on the fourth folding axis FX4 parallel to the second direction DR2. The display surface of the second folding region FAa-2 may be inner-folded such that the display surface of the second non-folding region NFAa-2 is disposed inside and the display surface of the third non-folding region NFAa-3 faces the display surface of the second non-folding region NFAa-2. The first folding region FAa-1 may be foldable or folded based on the third folding axis FX3 parallel to the second direction DR2. The first folding region FAa-1 may be inner-folded such that the rear surface of the third non-folding region NFAa-3 and the display surface of the first non-folding region NFAa-1 face each other.

The embodiment of the invention is not limited to the multi-folded states illustrated in FIGS. 3B and 3C and the electronic device may have various folding shapes.

In an embodiment of the invention, both an outer-folding operation and an inner-folding operation may be performed simultaneously, and only any one of the outer-folding operation and the inner-folding operation may be performed.

In an embodiment of the invention, the electronic devices ED, ED-a, and ED-b may be configured in a way such that an unfolding operation and an inner-folding or outer-folding operation are alternately repeated, but the embodiment of the invention is not limited thereto. In an embodiment of the invention, the electronic devices ED, ED-a, and ED-b may be configured in a way such that any one of an unfolding operation, an inner-folding operation, and an outer-folding operation is selectively performed. In an embodiment, where a plurality of folding regions are defined, the folding direction of at least one of the plurality of folding regions may be different from the folding direction of the remaining folding regions. In an embodiment, for example, where two folding regions are included, two non-folding regions with one folding region interposed therebetween may be folded by an inner-folding operation, and two non-folding regions with the other folding region interposed therebetween may be folded by an outer-folding operation.

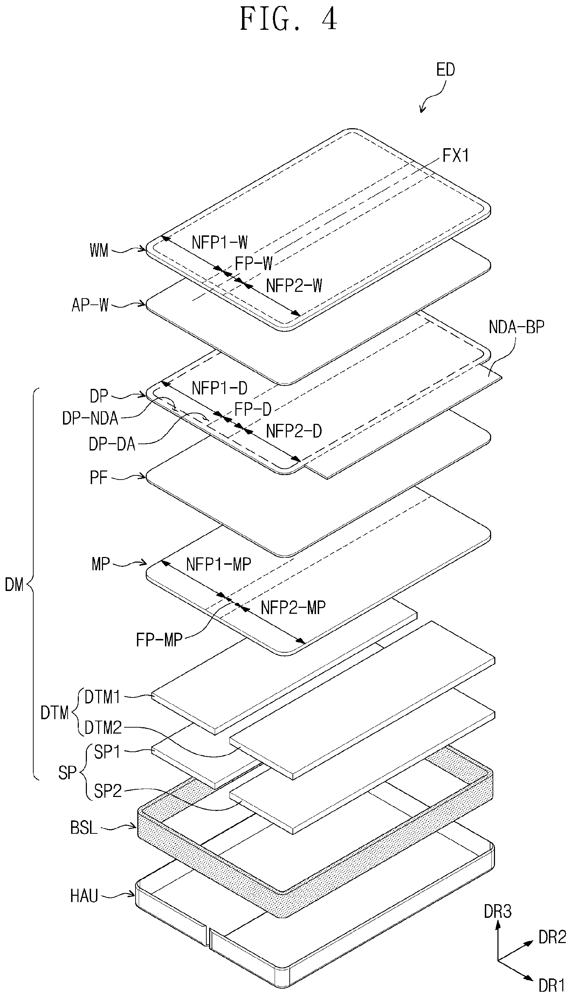

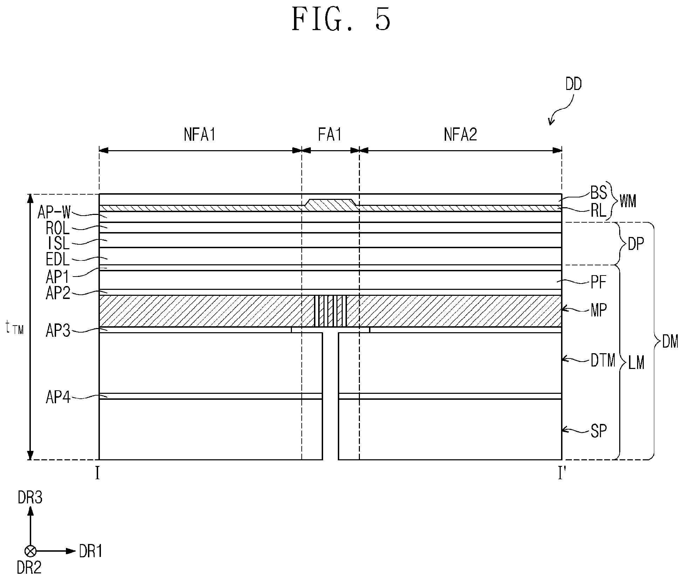

FIG. 4 is an exploded perspective view of an electronic device according to an embodiment of the invention. FIG. 5 is a cross-sectional view illustrating a portion of a display device according to an embodiment of the invention. FIG. 5 is a cross-sectional view illustrating a portion taken along line I-I' of FIG. 1.

FIGS. 4, 5, and the like illustrate an embodiment in which the folding axis FX1 of the electronic device ED is parallel to the long side of the electronic device ED as illustrated in FIG. 1A, but the embodiment of the invention is not limited thereto, and the content described with reference to the drawings below may also be applied to embodiments in which the folding axis FX2 is parallel to the short side of the electronic device as illustrated in FIG. 2A and the like, or to embodiments in which the electronic device is multi-folded as illustrated in FIG. 3A and the like.

The electronic device ED according to an embodiment of the invention may include a display module DM, a window WM, a housing HAU accommodating the display module DM and the window WM, and a sealing portion BSL disposed inside the housing HAU.

The display module DM may include a display panel DP and a lower module LM disposed below the display panel DP. The lower module LM may include a support plate MP. In addition, in an embodiment of the invention, in addition to the support plate MP, the display module DM may further include at least one selected from a protective layer PF, a support member SP, adhesive layers AP1, AP2, AP3, and AP4, or a digitizer module DTM in the lower module LM.

The display panel DP may display an image based on an electrical signal and transmit/receive information on an external input. The display panel DP may include a display region DP-DA and a non-display region DP-NDA. The display region DP-DA may be defined as a region from which an image provided by the display panel DP is output.

The non-display region DP-NDA is adjacent to the display region DP-DA. In an embodiment, for example, the non-display region DP-NDA may surround the display region DP-DA in a plan view or when viewed in the third direction DR3. However, this is illustrated as an example, and the non-display region DP-NDA may be defined in various shapes and is not limited to any one embodiment. In addition, the display panel DP may include a non-display bending portion NDA-BP disposed on at least one side of the non-display region DP-NDA. The non-display bending portion NDA-BP may be bent toward the lower side of the display module DM and be disposed to overlap at least a portion of the display panel DP. A circuit layer, a connection line, a circuit board, or the like for displaying an image or transmitting/receiving information may be mounted on or attached to the non-display bending portion NDA-BP.

In an embodiment of the invention, the display panel DP includes a display layer EDL. The display layer EDL may be a component that substantially generates an image. The image generated by the display layer EDL may be viewed by a user from the outside through the first display surface FS (see FIG. 1A). The display layer EDL may be a light-emitting display layer, but is not particularly limited thereto. In an embodiment, for example, the display layer EDL may be an organic light-emitting display layer or an inorganic light-emitting display layer. The organic light-emitting display layer may include a light-emitting element including an organic light-emitting material in a light-emitting layer. In addition, the inorganic light-emitting display layer may include a light-emitting element including materials such as quantum dots and quantum rods in a light-emitting layer.

The display panel DP may further include a sensor layer ISL. The sensor layer ISL may be disposed directly on the display layer EDL. The sensor layer ISL may include a plurality of sensing electrodes. The sensor layer ISL may sense an external input by a self-cap method or a mutual cap method. The sensor layer ISL may sense an input by an active-type input device.

In an embodiment, the sensor layer ISL may be formed directly on the display layer EDL through a continuous process when the display layer EDL is manufactured. However, the embodiment of the invention is not limited thereto, and the sensor layer ISL may be manufactured as a panel separate from the display layer EDL and then may be attached to the display layer EDL by an adhesive layer (not illustrated).

In an embodiment, the display panel DP may further include an optical layer ROL. The optical layer ROL may function to reduce reflection of external light. In an embodiment, for example, the optical layer ROL may include a polarizing layer or a color filter layer. However, the embodiment of the invention is not limited thereto, and the optical layer ROL may include optical members for improving the display quality of the display module DM.

In an embodiment of the invention, the optical layer ROL may be disposed directly on the sensor layer ISL. In an embodiment, where the sensor layer ISL is not provided on the display panel DP, the optical layer ROL may be disposed directly on the display layer EDL. However, the embodiment of the invention is not limited thereto, and the optical layer ROL may be disposed on the display layer EDL or the sensor layer ISL by using a separate adhesive member.

The display panel DP may include a folding display portion FP-D and non-folding display portions NFP1-D and NFP2-D. The folding display portion FP-D may correspond to the folding region FA1 (see FIG. 1A), and the non-folding display portions NFP1-D and NFP2-D may correspond to the non-folding regions NFA1 and NFA2 (see FIG. 1A). The folding display portion FP-D and the non-folding display portions NFP1-D and NFP2-D of the display panel DP may be respectively referred to as the folding display portion and the non-folding display portion of the display module DM.

The folding display portion FP-D may correspond to a portion that is foldable or bendable based on the folding axis FX1 (see FIG. 1A). The display panel DP may include a first non-folding display portion NFP1-D and a second non-folding display portion NFP2-D, and the first non-folding display portion NFP1-D and the second non-folding display portion NFP2-D may be spaced apart from each other in the first direction DR1 with the folding display portion FP-D interposed therebetween. The folding display portion FP-D may correspond to the folding region FA1 of the electronic device ED, and the first non-folding display portion NFP1-D and the second non-folding display portion NFP2-D may respectively correspond to the first non-folding region NFA1 and the second non-folding region NFA2 of the electronic device ED.

In an embodiment of the invention, the support plate MP may be disposed below the display panel DP. The support plate MP may include a folding support portion FP-MP and non-folding support portions NFP1-MP and NFP2-MP. A first non-folding support portion NFP1-MP and a second non-folding support portion NFP2-MP of the support plate MP may be spaced apart from each other in the first direction DR1 with the folding support portion FP-MP interposed therebetween. The folding support portion FP-MP may correspond to the folding region FA1 (see FIG. 1A), and the non-folding support portions NFP1-MP and NFP2-MP may correspond to the non-folding regions NFA1 and NFA2 (see FIG. 1A). The support plate MP will be described in more detail later. In the invention, when two elements correspond to each other, the two elements may overlap each other in the third direction DR3.

The display module DM according to an embodiment of the invention may further include a protective layer PF in the lower module LM. The protective layer PF may be disposed between the display panel DP and the support plate MP. The protective layer PF may be disposed below the display panel DP to protect the rear surface of the display panel DP. The protective layer PF may overlap the entire display panel DP. The protective layer PF may include a polymer material. In an embodiment, for example, the protective layer PF may be a polyimide film or a polyethylene terephthalate film. However, this is an example and the material of the protective layer PF is not limited thereto.

In an embodiment of the invention, the lower module LM may include a support member SP. The support member SP may include support layers SP1 and SP2. The support layers SP1 and SP2 may include a first support layer SP1 and a second support layer SP2 which are spaced apart from each other in the direction of the first direction axis DR1. The first support layer SP1 and the second support layer SP2 may be spaced apart from each other in a portion corresponding to the first folding axis FX1 (see FIG. 1A). In such an embodiment, as the support layers SP1 and SP2 are spaced apart from each other in the folding region FA1 and are provided as the first support layer SP1 and the second support layer SP2, it is possible to improve the folding or bending characteristics of the electronic device ED. In an embodiment, although not illustrated, the support layers SP1 and SP2 may further include a cushion layer (not illustrated) and a lower support plate (not illustrated) stacked in the thickness direction.

The electronic device ED according to an embodiment of the invention may further include a digitizer module DTM disposed below the support plate MP. The digitizer module DTM according to an embodiment of the invention may include a digitizer layer, a shielding layer, and the like. The digitizer module DTM may be included in the configuration of the lower module LM.

The digitizer module DTM may include a first digitizer module DTM1 and a second digitizer module DTM2 which are disposed to be spaced apart from each other in a portion overlapping the folding region FA1. The first digitizer module DTM1 may be disposed to correspond to the first non-folding region NFA1, and the second digitizer module DTM2 may be disposed to correspond to the second non-folding region NFA2.

That is, in an embodiment of the invention, the first digitizer module DTM1 and the second digitizer module DTM2 may be spaced apart from each other in a region overlapping the folding display portion FP-D. The first digitizer module DTM1 may overlap the first non-folding display portion NFP1-D, and the second digitizer module DTM2 may overlap the second non-folding display portion NFP2-D.

In addition, the electronic device ED according to an embodiment of the invention may further include at least one of adhesive layers AP1, AP2, AP3, and AP4. In an embodiment, for example, the first adhesive layer AP1 may be disposed between the display panel DP and the protective layer PF, and the second adhesive layer AP2 may be disposed between the protective layer PF and the support plate MP. The third adhesive layer AP3 and the fourth adhesive layer AP4 may be disposed between the support plate MP and the support member SP. At least one of the adhesive layers AP1, AP2, AP3, and AP4 may be an optically clear adhesive film (OCA) or an optically clear adhesive resin layer (OCR). However, the embodiment of the invention is not limited thereto, and at least one of the adhesive layers AP1, AP2, AP3, and AP4 may have a low transmittance of about 80% or less.

FIGS. 4, 5, and the like illustrate an embodiment where the lower module LM includes all of the protective layer PF, the support plate MP, the support member SP, the adhesive layers AP1, AP2, AP3, and AP4, and the digitizer module DTM, but the embodiment of the invention is not limited to what is illustrated, and the configuration of the lower module LM may include some of the components listed above in consideration of mechanical properties, shapes, and operating characteristics required for the display device DD or the electronic device ED, or more components may be added in addition to the components of the lower module presented above.

The display device DD according to an embodiment of the invention includes a window WM disposed on the display module DM. The window WM may be disposed on an upper surface of the display panel DP. The window WM may include a folding portion FP-W and non-folding portions NFP1-W and NFP2-W. The first non-folding portion NFP1-W and the second non-folding portion NFP2-W of the window WM may be spaced apart from each other in the first direction DR1 with the folding portion FP-W interposed therebetween. The folding portion FP-W may correspond to the folding region FA1 of the electronic device ED (see FIG. 1A), and the non-folding portions NFP1-W and NFP2-W may correspond to the non-folding regions NFA1 and NFA2. In addition, the folding portion FP-W may correspond to the folding display portion FP-D, and the non-folding portions NFP1-W and NFP2-W may correspond to the non-folding display portions NFP1-D and NFP2-D.

The window WM may cover an entire upper surface of the display module DM. In an embodiment of the invention, the window WM may function as a cover window of the electronic device ED. The electronic device ED and the display device DD according to an embodiment of the invention do not include a cover member, a protective film, or the like which is separated from the window WM and provided as a separate member on the window WM. In an embodiment of the invention, the window WM may correspond to an uppermost member of the electronic device ED or the display device DD.

In an embodiment of the invention, the window WM may include a base glass BS and a resin layer RL. The resin layer RL may be disposed on an upper or lower surface of the base glass BS. In the drawings, the resin layer RL is illustrated to cover the lower and side surfaces of the base glass BS, but without being limited thereto, the resin layer RL may be disposed on the upper surface of the base glass BS, or the resin layer RL may be disposed to cover the upper and side surfaces of the base glass BS.

The window WM according to an embodiment of the invention may exhibit high durability by including the resin layer RL. The window WM according to an embodiment of the invention may exhibit high impact resistance by including the resin layer RL.

Table 1 below shows the results of evaluating the edge strength characteristics of Comparative examples in which the window was composed of only a base glass and an Examples in which the window included a base glass and a resin layer. The edge strengths in Table 1 below were evaluated by using a Charpy impact strength evaluation method. A tip that applied an impact was made of acetal (1.5 kg), the shape of the tip was round, and the curvature of the round tip was 3R. The weight of a shaft providing an impact was 202 g and the length thereof was 30 cm. The inclination angle of the shaft providing the impact started from 2° and was increased until samples to be evaluated were damaged, and the angle was increased by 1° during evaluation. The samples used to evaluate edge strength characteristics were placed on an evaluation plate, and the samples were fixed with a clamp so that a portion to which the impact was applied protruded 1 mm from the plate.

**[Table 1]**

| Division | Damage angle (°) | | |
|---|---|---|---|
| | Average | Maximum | Minimum |
| Comparative example 1 | 3.5 | 5 | 3 |
| Example 1 | 5.7 | 7 | 4 |
| Comparative example 2 | 3.7 | 6 | 2 |
| Example 2 | 6.1 | 7 | 4 |

A same base glass was used in Comparative example 1 and Example 1, and a same base glass was used in Comparative example 2 and Example 2. Referring to the results of Comparative examples and Examples, it can be seen that the windows in which a resin layer was provided to a base glass have high impact resistance and edge strength when compared to the windows composed of only a base glass.

In an embodiment of the invention, the resin layer RL may include a urethane-based resin and a silane-based additive. That is, the resin layer RL may include or be formed of a composite resin including both organic and inorganic materials. In an embodiment of the invention, the resin layer RL may include or be formed of an organic-inorganic hybrid resin. Accordingly, in an embodiment of the invention, high adhesion may be exhibited with respect to both an inorganic material layer and an organic material layer which are adjacent to the resin layer RL.

In an embodiment of the invention, the content of the urethane-based resin included in the resin layer RL may be in a range of about 2 weight percent (wt%) to about 70 wt%, and the content of the silane-based additive included therein may be about 5 wt% or less. In an embodiment, for example, the content of the urethane-based resin included in the resin layer RL may be in a range of about 18 wt% to about 28 wt%, and the content of the silane-based additive included therein may be about 1 wt% or less.

The resin layer RL may have physical properties in which it has a modulus (e.g., Young's modulus) of about 50 megapascals (MPa) or greater at about 25°C, a modulus of about 1000 MPa or less at about -20°C, and a modulus of about 500 MPa or less at about 60°C. In an embodiment, for example, the resin layer RL may have a modulus in a range of about 50 MPa to about 1000 MPa at about 25°C, a modulus in a range of about 100 MPa to about 1000 MPa at about -20°C, and a modulus in a range of about 10 MPa to about 500 MPa at about 60°C.

In an embodiment of the invention, as the resin layer RL has a modulus value of about 50 MPa or greater at room temperature (about 25°C), the window WM may exhibit high point load strength and high side surface strength characteristics. In addition, the buckling of the window WM may be minimized. When the resin layer RL has a modulus value of less than about 50 MPa at room temperature, buckling may occur, and when the resin layer RL has a modulus value of more than 1000 MPa at room temperature, the impact resistance strength thereof may decrease.

In an embodiment of the invention, as the resin layer RL has a modulus value of about 1000 MPa or less at a low temperature (about -20°C), the high planar and lateral strength of the window WM may be maintained and the high folding characteristics thereof may be maintained at a low temperature. In a case in which the resin layer RL has a modulus value of less than about 100 MPa at a low temperature, coating processability may be deteriorated when the resin layer RL is provided to the base glass BS, or the handling of the window WM may not be easy due to low modulus characteristics. In a case in which the resin layer RL has a modulus value of more than about 1000 MPa at a low temperature, a crack may occur in the resin layer RL.

In addition, as the resin layer RL has a modulus value of about 500 MPa or less at a high temperature (about 60°C), high folding characteristics may be maintained at a high temperature. In a case in which the resin layer RL has a modulus value of less than about 10 MPa at a high temperature, coating processability may be deteriorated when the resin layer RL is provided to the base glass BS, or the handling of the window WM may not be easy due to low modulus characteristics. In addition, In a case in which the resin layer RL has a modulus value of more than about 500 MPa at a high temperature, a crack may occur in the resin layer RL.

That is, as the resin layer RL according to an embodiment of the invention has mechanical properties in which it has a modulus of about 50 MPa or greater at about 25°C, a modulus of about 1000 MPa or less at about -20°C, and a modulus of about 500 MPa or less at about 60°C, high impact resistance, high durability, and desirable folding characteristics may be maintained not only at room temperature but also at low and high temperatures. The window WM according to an embodiment of the invention will be described in greater detail later.

The electronic device ED according to an embodiment of the invention includes a sealing portion BSL. The sealing portion BSL may be included as a component of the display device DD. The sealing portion BSL may be disposed between the window WM and the housing HAU and between the display module DM and the housing HAU. The sealing portion BSL may cover the side surface of the window WM and the side surface of the display module DM. The sealing portion BSL may fill a space between the housing HAU and the side surface of the window WM and a space between the housing HAU and the side surface of the display module DM.

The sealing portion BSL may include a black coloring agent. The black coloring agent may include a black pigment or black dye. The optical density (OD) of the sealing portion BSL may be about 2 or greater. The sealing portion BSL may be viewed as a black layer with an optical density of about 2 or greater, light may be effectively prevented from leaking to the outside of the display surface FS (see FIG. 1A), outer components below the display panel DP may be effectively prevented from being viewed from the outside.

The sealing portion BSL may replace a deco (or decoration) layer among the components of a typical electronic device. As the electronic device ED according to an embodiment of the invention or the display device DD according to an embodiment of the invention includes a sealing portion BSL surrounding the side edges of the window WM and the display module DM, it is possible to exhibit the characteristics of the exterior divided by the display surface (see FIG. 1A) even when the deco layer is omitted, and at the same time, the sealing portion may protect the side surfaces of the window WM and the display module DM, thereby exhibiting high durability.

The sealing portion BSL may function as an adhesive layer. The sealing portion BSL may couple the housing HAU and the window WM to each other and may also couple the housing HAU and the display module DM to each other.

The window WM and the display module DM may be accommodated in the housing HAU. In addition, the sealing portion BSL may be disposed within the housing HAU. The housing HAU may further include a hinge structure to facilitate folding or bending.

In the display device DD according to an embodiment of the invention, the window WM includes the base glass BS and the resin layer RL, such that high durability may be exhibited even when a separate protection member is not disposed on the window WM, and the thickness of the display device DD may also be reduced.

In the display device DD according to an embodiment of the invention, a thickness t_{TM} from the lowermost surface of the display module DM to the upper surface of the window WM may be about 700 micrometers (µm) or less. Accordingly, the display device DD may exhibit the characteristics of being slim when compared to a typical display device for which a separate protection member is included.

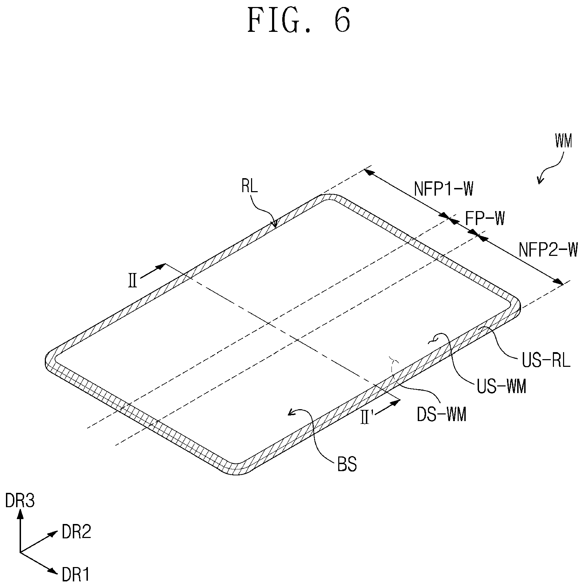

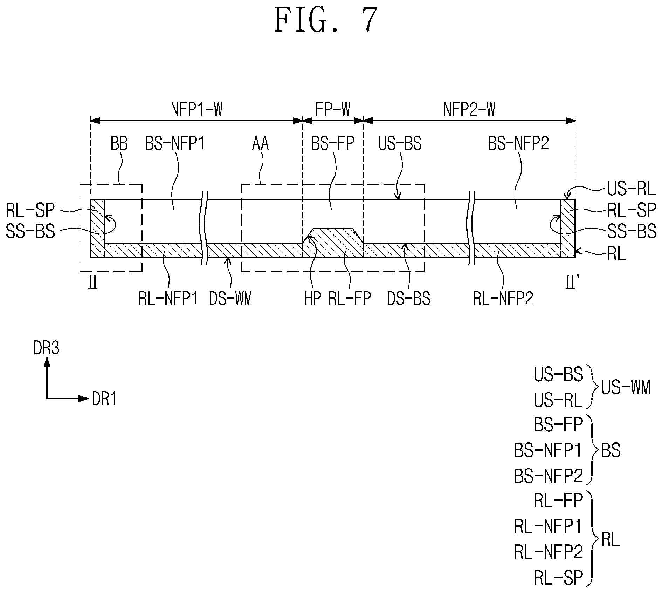

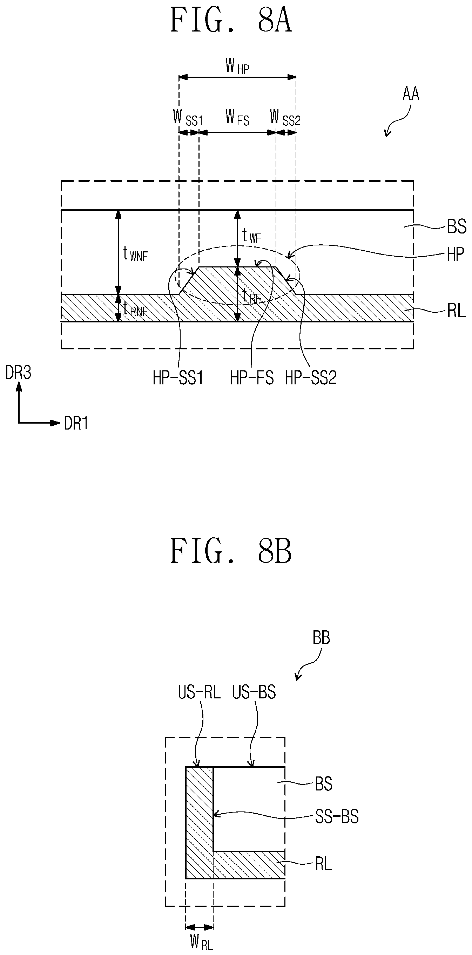

FIG. 6 is a perspective view of a window according to an embodiment of the invention. FIG. 7 is a cross-sectional view of the window according to an embodiment of the invention. FIGS. 8A and 8B are cross-sectional views illustrating a portion of the window according to an embodiment of the invention. FIG. 7 may be a cross-sectional view taken along line II-II' of FIG. 6. FIG. 8A may be an enlarged view of a region AA of FIG. 7, and FIG. 8B may be an enlarged view of a region BB of FIG. 7.

Referring to FIGS. 6 to 8B, the window WM according to an embodiment of the invention may include a base glass BS and a resin layer RL. In the window WM according to an embodiment of the invention, the resin layer RL may cover one surface (e.g., one of an upper surface and a lower surface) and a side surface of the base glass BS.

In the window WM according to an embodiment of the invention, the base glass BS may be a tempered glass substrate. The base glass BS may be an ultrathin tempered glass substrate. The resin layer RL may be a layer that is materially distinct from the base glass BS. As described above, the resin layer RL may be a composite material layer including organic and inorganic materials. In an embodiment of the invention, for example, the resin layer RL may include a urethane-based resin and a silane-based additive.

The window WM according to an embodiment of the invention may include a folding portion FP-W and non-folding portions NFP1-W and NFP2-W. The window WM may include an upper surface US-WM, which is a flat surface, and a lower surface DS-WM, which faces the upper surface and is a flat surface. The upper surface US-WM of the window may correspond to the upper surface of the display device DD (see FIG. 5), and the lower surface DS-WM of the window may be adjacent to the display module DM. In an embodiment of the invention, the upper surface US-WM of the window may be the uppermost surface of the display device DD or the uppermost surface of the electronic device ED (see FIG. 1A).

The base glass BS may be divided into a folding portion BS-FP and a first non-folding portion BS-NFP1 and a second non-folding portion BS-NFP2 spaced apart from each other with the folding portion BS-FP interposed therebetween.

The base glass BS may include a groove portion HP. The groove portion HP is a portion having an average thickness which is smaller than the thickness of other portions of the base glass BS and may be referred to as a slimming region. The groove portion HP may be included in the folding portion BS-FP.

The base glass BS may include a base upper surface US-BS, a base lower surface DS-BS facing the base upper surface US-BS, and a base side surface SS-BS disposed between the base upper surface US-BS and the base lower surface DS-BS. In an embodiment of the invention, the base upper surface US-BS may be a flat surface, and a groove portion HP may be defined in the base lower surface DS-BS. The groove portion HP may be defined to be concave in the direction of the base upper surface US-BS. The base upper surface US-BS may be referred to as a first surface, and the base lower surface DS-BS may be referred to as a second surface.

In addition, the groove portion HP of the base glass BS may be defined by a slimming upper portion HP-FS which is a flat surface facing the base upper surface US-BS, a first diagonal (or inclined) surface HP-SS1 extending from the slimming upper portion HP-FS to the base lower surface DS-BS of the first non-folding portion BS-NFP1, and a second diagonal (or inclined) surface HP-SS2 extending from the slimming upper portion HP-FS to the base lower surface DS-BS of the second non-folding portion BS-NFP2.

In an embodiment, as shown in FIG. 8A, a width W_{HP} of the groove portion HP in the first direction DR1 (i.e., a direction perpendicular to a folding axis FX1) in the base glass BS may be in a range of about 7 millimeters (mm) to about 50 mm. In an embodiment, for example, the width W_{HP} of the groove portion HP in the first direction DR1 may be in a range of about 7 mm to about 50 mm. Since the groove portion HP has a width W_{HP} in a range of about 7 mm to about 50 mm, the window WM may have a small folding radius and exhibit good or desirable folding characteristics.

The width W_{HP} of the groove portion HP includes a width W_{FS} of the slimming upper portion HP-FS in the first direction DR1, a width W_{SS1} of the first diagonal surface HP-SS1 in the first direction DR1, and a width W_{SS2} of the second diagonal surface HP-SS2 in the first direction DR1.

In the groove portion HP, the width W_{FS} of the slimming upper portion HP-FS in the first direction DR1 may be in a range of about 1 mm to about 30 mm, and each of the width W_{SS1} of the first diagonal surface HP-SS1 in the first direction DR1 and the width W_{SS2} of the second diagonal surface HP-SS2 in the first direction DR1 may be in a range of about 3 mm to about 15 mm.

In an embodiment of the invention, a thickness t_{WNF} of the non-folding portions BS-NFP1 and BS-NFP2 of the base glass BS may be about 70 µm or greater. In an embodiment of the invention, the thickness t_{WNF} of the non-folding portions BS-NFP1 and BS-NFP2 of the base glass BS may be in a range of about 150 µm to about 300 µm. In an embodiment, for example, the thickness t_{WNF} of the non-folding portions BS-NFP1 and BS-NFP2 of the base glass BS may be in a range of about 150 µm to about 250 µm.

As the base glass BS has a thickness of about 70 µm or greater in the non-folding portions BS-NFP1 and BS-NFP2, the window WM may have sufficient strength and impact resistance even when a separate cover member or protective film is not provided thereon. In addition, as the non-folding portions BS-NFP1 and BS-NFP2 of the base glass BS have a thickness of about 70 µm or greater, the window WM according to an embodiment of the invention may have high surface quality characteristics. As the non-folding portions BS-NFP1 and BS-NFP2 of the base glass BS have a thickness of about 70 µm or greater, the occurrence of creases may be reduced in the window WM according to an embodiment of the invention.

In an embodiment of the invention, a thickness t_{WF} of the folding portion BS-FP of the base glass BS may be about 30 µm or greater. The thickness t_{WF} of the folding portion BS-FP of the base glass BS may be in a range of about 30 µm to about 80 µm. In an embodiment, for example, the thickness t_{WF} of the folding portion BS-FP of the base glass BS may be in a range of about 40 µm to about 70 µm.

As the base glass BS has a thickness of about 30 µm or greater in the folding portion BS-FP, it may have high durability when folded, and as the base glass BS has a thickness of about 80 µm or less, it may exhibit desirable or good folding characteristics that allow for free folding motion.

In the window WM according to an embodiment of the invention, the resin layer RL may be disposed to fill the groove portion HP of the base glass BS. Referring to FIGS. 6 and 7, in an embodiment of the invention, the resin layer RL may be disposed to entirely cover the base lower surface DS-BS and the base side surface SS-BS. The resin layer RL may be disposed to entirely surround the side surface of the base glass BS on a plane defined by the first direction axis DR1 and the second direction axis DR2.

The resin layer RL may include a folding resin portion RL-FP, non-folding resin portions RL-NFP1 and RL-NFP2, and a side resin portion RL-SP. The folding resin portion RL-FP may be disposed below the base glass BS to correspond to the folding display portion FP-D, and the non-folding resin portions RL-NFP1 and RL-NFP2 may be disposed below the base glass BS to correspond to the non-folding display portions NFP1-D and NFP2-D. The folding resin portion RL-FP may overlap the folding portion BS-FP of the base glass BS, and the non-folding resin portions RL-NFP1 and RL-NFP2 may overlap the non-folding portions BS-NFP1 and BS-NFP2 of the base glass BS.

The side resin portion RL-SP may cover at least a portion of the base side surface SS-BS. In an embodiment of the invention, the side resin portion RL-SP may entirely cover the base side surface SS-BS. As the resin layer RL includes the side resin portion RL-SP that covers the base side surface SS-BS, the window WM according to an embodiment of the invention may exhibit high characteristics in terms of side durability as well.

In an embodiment, as shown in FIG. 8A, a maximum thickness t_{RF} of the resin layer RL may be about 30 µm or greater. That is, the maximum thickness t_{RF} of the folding resin portion RL-FP of the resin layer RL may be about 30 µm or greater. The maximum thickness t_{RF} of the resin layer RL may be in a range of about 100 *µ* m to about 300 µm. In an embodiment, for example, the maximum thickness t_{RF} of the resin layer RL may be in a range of about 100 µm to about 250 µm.

In the window WM according to an embodiment of the invention, the resin layer RL has a thickness t_{RF} of about 30 µm or greater in a portion in which the resin layer RL disposed in the folding portion FP-W has the greatest thickness, and therefore, in the window WM according to an embodiment of the invention, the folding portion FP-W may exhibit high strength characteristics due to the resin layer RL having a sufficient thickness. The resin layer RL may function to attenuate an impact and the like applied to the window WM.

A thickness t_{RNF} of the non-folding resin portions RL-NFP1 and RL-NFP2 of the resin layer RL may be in a range of about 5 µm to about 100 µm. In an embodiment, for example, the thickness t_{RNF} of the non-folding resin portions RL-NFP1 and RL-NFP2 may be in a range of about 10 µm to about 50 µm.

In an embodiment of the invention, the upper surface US-WM of the window may be composed of or defined by the base upper surface US-BS and the upper surface US-RL of the resin layer RL surrounding the base glass BS. That is, in an embodiment of the invention, the upper surface US-WM of the window may be composed of or defined by the base upper surface US-BS and the upper surface US-RL of the side resin portion RL-SP. In an embodiment of the invention, the upper surface of the display device DD (see FIG. 5) may be composed of or defined by the base upper surface US-BS and the upper surface US-RL of the side resin portion RL-SP.

In an embodiment of the invention, a width W_{RL} of the side resin portion RL-SP may be in a range of about 50 µm to about 300 µm. In an embodiment, for example, the width W_{RL} of the side resin portion RL-SP may be in a range of about 100 µm to about 300 µm.

In an embodiment, as shown in FIG. 8B, the width W_{RL} of the side resin portion RL-SP corresponds to the width of the resin layer RL included in the upper surface of the window and surrounding the base glass BS. As the side resin portion RL-SP has a width W_{RL} of about 50 µm or greater, the side durability of the window WM may be improved, and as the side resin portion RL-SP has a width W_{RL} of about 300 µm or less, the display device or the electronic device ED (see FIG. 4) on a plane may be slimmed.

Hereinafter, a display device according to an embodiment of the invention, an electronic device according to an embodiment of the invention, and a window according to an embodiment of the invention will be described with reference to drawings, and in the description of the embodiments, the same or like elements as those described above with reference to FIGS. 1A to 8B will be omitted and differences will be mainly described.

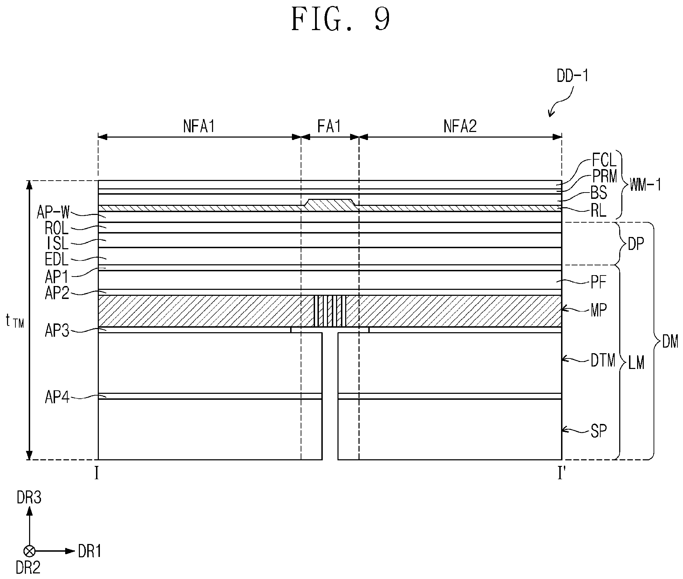

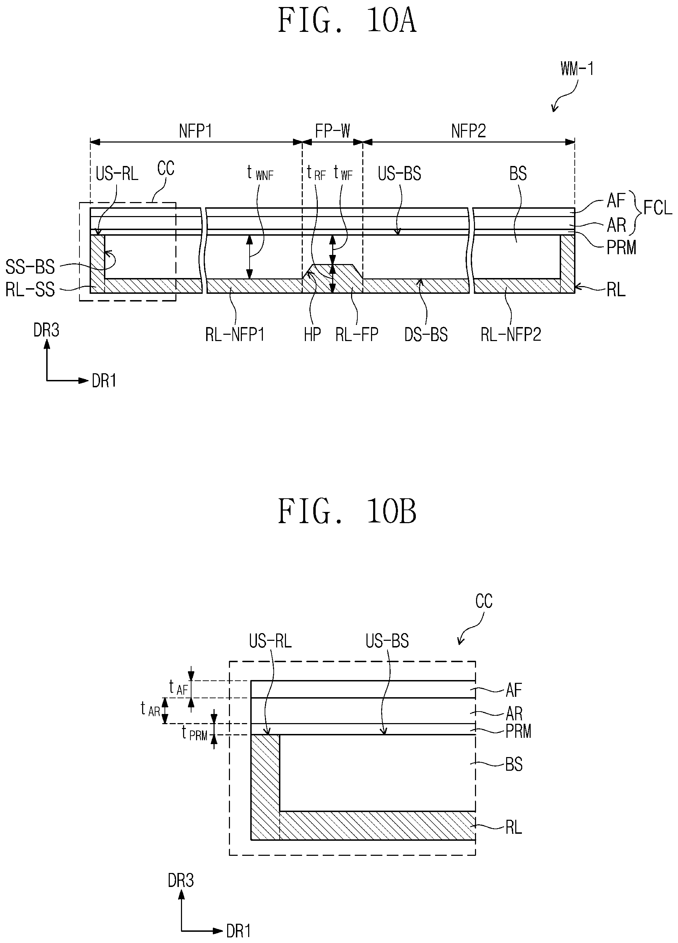

FIG. 9 is a cross-sectional view of a display device according to an embodiment of the invention. FIG. 10A is a cross-sectional view of a window according to an embodiment of the invention, and FIG. 10B is a cross-sectional view illustrating a portion of the window according to an embodiment of the invention.

FIG. 9 may be a cross-sectional view taken along line I-I' of FIG. 1A. FIG. 10A is a cross-sectional view of a window included in the display device of FIG. 9. FIG. 10B may be a cross-sectional view of a region CC of FIG. 10A.

A display device DD-1 according to an embodiment of the invention, which is illustrated in FIG. 9, is substantially the same as the display device DD according to the embodiment of the invention illustrated in FIG. 5 except for window configuration. As shown in FIG. 9, the display device DD-1 according to an embodiment of the invention may include a window WM-1 and a display module DM disposed below the window WM-1. The display module DM may include a display panel DP and a lower module LM. The lower module LM may include a support plate MP.

Referring to FIGS. 9 to 10B, the window WM-1 according to an embodiment of the invention may include a base glass BS, a resin layer RL, and a functional layer FCL. The window WM-1 according to an embodiment of the invention includes the base glass BS, the resin layer RL, and the functional layer FCL and may further include a primer layer PRM.

In an embodiment of the invention, the upper surface of the window WM-1 may correspond to the upper surface of the functional layer FCL. In an embodiment of the invention, the upper surface of the functional layer FCL may define the uppermost surface of the display device DD-1.

In the display device DD-1 according to an embodiment of the invention, the window WM-1 may include the base glass BS, the resin layer RL, and the functional layer FCL, or the base glass BS, the resin layer RL, the functional layer FCL, and the primer layer PRM, the window WM-1 may exhibit high durability even when no separate protection member is disposed on the window WM-1, and the overall thickness of the display device DD-1 may be reduced.

In the display device DD-1 according to an embodiment of the invention, the thickness t_{TM} from the lowermost surface of the display module DM to the upper surface of the window WM-1, which is the uppermost surface of the window WM-1, may be about 700 µm or less. Accordingly, the display device DD-1 may exhibit the characteristics of being slim when compared to a typical display device for which a separate protection member is used.

In an embodiment of the invention, the functional layer FCL may include at least one selected from a reflection reduction layer AR or an anti-fingerprint layer AF. In an embodiment of the invention, the functional layer FCL may include a reflection reduction layer AR and an anti-fingerprint layer AF disposed on the reflection reduction layer AR. In an embodiment where the functional layer FCL includes both the reflection reduction layer AR and the anti-fingerprint layer AF, the upper surface of the anti-fingerprint layer AF may be the uppermost surface of the display device DD-1. In an embodiment where the functional layer FCL includes both the reflection reduction layer AR and the anti-fingerprint layer AF, the thickness t_{TM} from the uppermost portion of the display module DM to the upper surface of the anti-fingerprint layer AF may be about 700 µm or less.

The reflection reduction layer AR may be a functional layer having optical characteristics in which reflectance is about 2% or less at a wavelength of about 550 nanometers (nm) (i.e., for light having a wavelength of about 550 nm). The anti-fingerprint layer AF may be a functional layer having characteristics in which the water contact angle thereof is about 100 degrees or greater. The thickness t_{AR} of the reflection reduction layer AR may be in a range of about 50 nm to about 1000 nm, and the thickness t_{AF} of the anti-fingerprint layer may be in a range of about 5 nm to about 50 nm.

The resin layer RL may be disposed to cover the base lower surface DS-BS and base side surface SS-BS of the base glass BS. The resin layer RL may include a folding resin portion RL-FP, non-folding resin portions RL-NFP1 and RL-NFP2, and a side resin portion RL-SS.

The maximum thickness t_{RF} of the folding resin portion RL-FP of the resin layer RL may be about 30 µm or greater. The maximum thickness t_{RF} of the resin layer RL may be in a range of about 100 µm to about 300 µm.

In an embodiment of the invention, the thickness t_{WNF} of the non-folding portions BS-NFP1 and BS-NFP2 of the base glass BS may be about 70 µm or greater, and the thickness t_{WF} of the folding portion BS-FP may be about 30 µm or greater. In an embodiment, for example, the thickness t_{WNF} of the non-folding portions BS-NFP1 and BS-NFP2 of the base glass BS may be in a range of about 150 µm to about 300 µm, and the thickness t_{WF} of the folding portion BS-FP may be in a range of about 30 µm to about 80 µm.

The functional layer FCL may entirely overlap the base glass BS and the side resin portion RL-SS. In an embodiment where the window WM-1 includes the base glass BS, the resin layer RL, and the functional layer FCL, the functional layer FCL may be disposed directly on the base upper surface US-BS and the upper surface US-RL of the side resin portion RL-SS.

In an embodiment where the window WM-1 further includes a primer layer PRM, the primer layer PRM may be disposed below the functional layer FCL. The primer layer PRM may be disposed directly on the lower surface of the functional layer FCL. The primer layer PRM may serve to increase the adhesive force of the functional layer FCL to an underlying member. The primer layer PRM may be an adhesive force improvement layer.

A thickness t_{PRM} of the primer layer PRM may be about 5 µm or less. The primer layer PRM may include at least one of an epoxy-based resin, an amino-based resin, a mercapto-based resin, or methoxy silane.

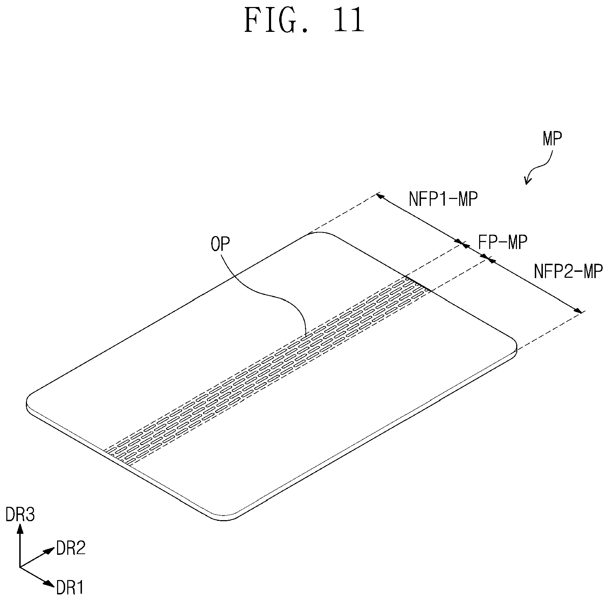

FIG. 11 is a perspective view illustrating a support plate according to an embodiment of the invention. In an embodiment of the invention, the support plate MP may include a metallic material or a non-metallic material. In an embodiment, for example, the support plate MP may include any one of stainless steel, titanium, and a fiber-reinforced composite material. The fiber-reinforced composite material may be carbon fiber-reinforced plastic (CFRP) or glass fiber-reinforced plastic (GFRP). In an embodiment of the invention, the support plate MP may include a metallic material or a non-metallic material. In an embodiment, for example, the support plate MP may include any one of stainless steel, titanium, and a fiber-reinforced composite material. The fiber-reinforced composite material may be carbon fiber-reinforced plastic (CFRP) or glass fiber-reinforced plastic (GFRP).

The support plate MP may include a folding support portion FP-MP and non-folding support portions NFP1-MP and NFP2-MP. A first non-folding support portion NFP1-MP and a second non-folding support portion NFP2-MP of the support plate MP may be spaced apart from each other in the first direction DR1 with the folding support portion FP-MP interposed therebetween. The folding support portion FP-MP may correspond to the folding region FA1 (see FIG. 1A), and the non-folding support portions NFP1-MP and NFP2-MP may correspond to the non-folding regions NFA1 and NFA2 (see FIG. 1A).

A plurality of openings OP may be defined in the support plate MP to correspond to the folding region FA1 (see FIG. 1A) of the electronic device ED (see FIG. 1A). The openings OP may be defined in the folding support portion FP-MP of the support plate MP. Stress applied to the support plate MP during a folding operation as illustrated in FIGS. 1B and 1C may be reduced by the openings OP defined to correspond to the folding region FA1 (see FIG. 1A).

The folding support portion FP-MP and the non-folding support portions NFP1-MP and NFP2-MP of the support plate MP may be formed of a same material. The folding support portion FP-MP and the non-folding support portions NFP1-MP and NFP2-MP may be integrally formed with each other.

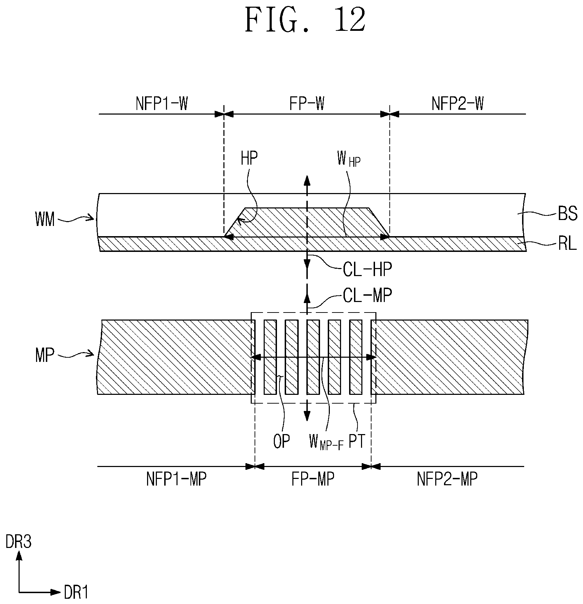

FIG. 12 is a cross-sectional view illustrating an arrangement form of the window and the support plate in the display device according to an embodiment of the invention. In FIG. 12, other components of the display device illustrated in FIG. 5 and the like are omitted for convenience of illustration and only the arrangement relationship of the window WM and the support plate MP is illustrated.

The folding support portion FP-MP may correspond to a pattern portion PT in which a plurality of openings OP are defined.

In an embodiment of the invention, the entire folding support portion FP-MP may overlap the groove portion HP of the window WM in the third direction DR3. The width W_{HP} of the groove portion HP in the first direction DR1 may be greater than a width W_{MP-F} of the folding support portion FP-MP in the first direction DR1. In an embodiment of the invention, the width W_{HP} of the groove portion HP in the first direction DR1 may be in a range of about 7 mm to about 50 mm, and the width W_{MP-F} of the folding support portion FP-MP in the first direction DR1 may be in a range of about 5 mm to about 20 mm.

In an embodiment of the invention, each of at least a portion of the first non-folding support portion NFP1-MP and at least a portion of the second non-folding support portion NFP2-MP may overlap the folding portion FP-W of the window.

In an embodiment of the invention, a center line CL-HP of the folding portion FP-W of the window WM and a center line CL-MP of the folding support portion FP-MP of the support plate MP may overlap each other.

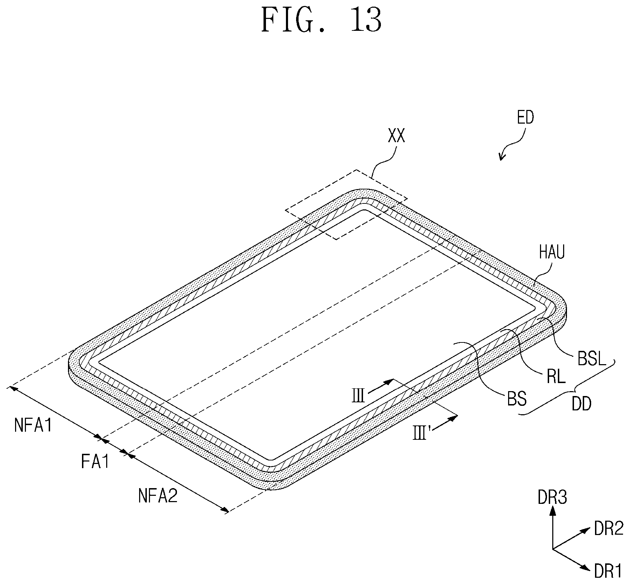

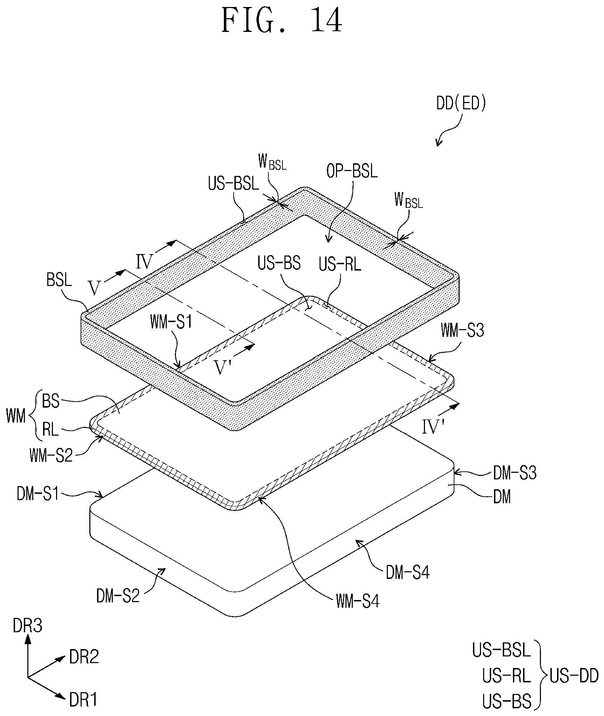

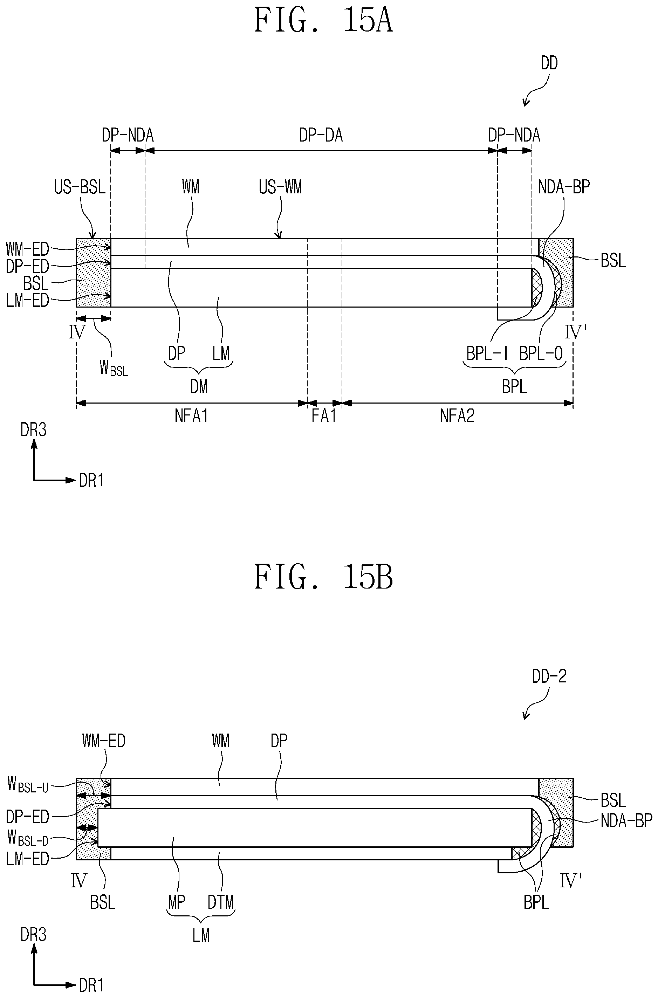

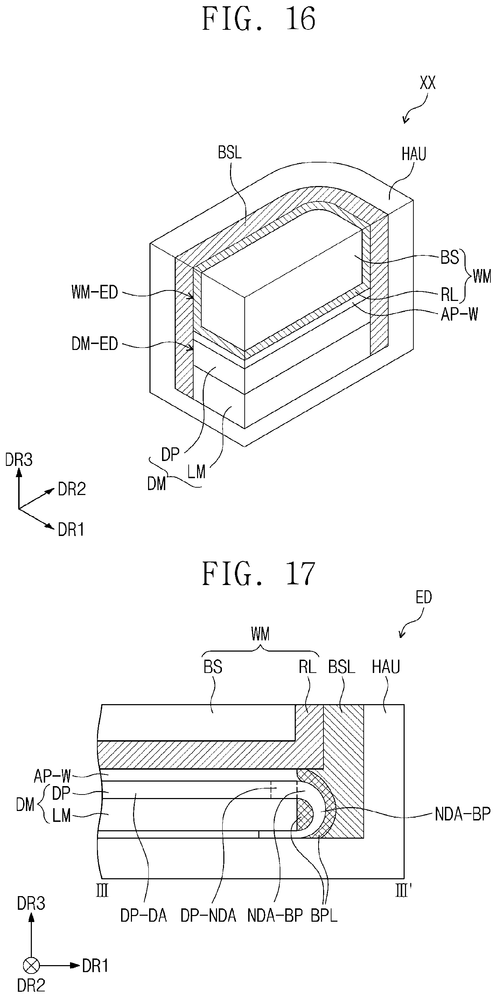

FIG. 13 is a perspective view of an electronic device according to an embodiment of the invention. FIG. 14 is an exploded perspective view of the electronic device according to an embodiment of the invention which is included in FIG, 13. Each of FIGS. 15A and 15B is a cross-sectional view of a partial region of a display device according to an embodiment of the invention. FIG. 16 is a perspective view of a partial region of the electronic device according to an embodiment of the invention. FIG. 17 is a cross-sectional view of a partial region of the electronic device according to an embodiment of the invention.

The cross-sectional view of the display device according to an embodiment of the invention which is illustrated in each of FIGS. 15A and 15B may correspond to a cross-sectional view taken along line IV-IV' in FIG. 14. FIG. 16 may be a perspective view of a region XX in FIG. 13, and FIG. 17 may be a cross-sectional view illustrating a portion corresponding to line III-III' in FIG. 13.

Referring to FIG. 13, when viewed on a plane defined by the first direction axis DR1 and the second direction axis DR2 (i.e., when viewed in a plan view or in the third direction DR3), the electronic device ED according to an embodiment of the invention may include a housing HAU and a display device DD disposed within the housing HAU. When viewed on a plane, the upper surface of the display device DD included in the electronic device ED may include a window WM and a sealing portion BSL disposed between the window WM and the housing HAU. On a plane, the sealing portion BSL may have a shape that surrounds the entire exterior of the window WM.

The upper surface of the window WM may be defined by ro composed of the upper surface of the base glass BS and the upper surface of the resin layer RL surrounding the base glass BS. The sealing portion BSL may have a shape that surrounds the exterior of the resin layer RL.

The upper surface of the electronic device ED according to an embodiment of the invention may be defined by or composed of the upper surface of the base glass BS, the upper surface of the resin layer RL surrounding the base glass BS, and the upper surface of the sealing portion BSL surrounding the resin layer RL. The upper surface of the electronic device ED may correspond to the display surface FS (see FIG. 1A). In addition, the exterior of the electronic device ED may be defined by or composed of the housing HAU.

Referring to FIG. 14 and the like, the display device DD according to an embodiment of the invention may include a display module DM, a window WM disposed on the display module DM, and a sealing portion BSL covering side surfaces DM-S1, DM-S2, DM-S3, and DM-S4 of the display module DM and sides surfaces WM-S1, WM-S2, WM-S3, and WM-S4 of the window WM. On a plane, the sealing portion BSL may have a shape that surrounds the window WM and the display module DM. In the invention, the side surfaces DM-S1, DM-S2, DM-S3, and DM-S4 of the display module DM may refer to the side surfaces of the display panel DP.

The sealing portion BSL may have a shape that surrounds the side surfaces DM-S1, DM-S2, DM-S3, and DM-S4 of the display module DM and the side surfaces WM-S1, WM-S2, WM-S3, and WM-S4 of the window WM such that an internal space OP-BSL is defined. As described above with reference to FIG. 4 and the like, the sealing portion BSL may include a black coloring agent.

In an embodiment, a width W_{BSL} of the sealing portion BSL on a plane may be in a range of about 100 µm to about 300 µm. In FIGS. 14, 15A, and the like, the width W_{BSL} of the sealing portion BSL may indicate the width of the sealing portion BSL that defines the upper surface of the display device DD. In such an embodiment, since the sealing portion BSL has a width W_{BSL} of about 100 µm or greater, the side surfaces of the display module DM and the window WM may be sufficiently protected, and the durability of the electronic device ED may be improved. In addition, the electronic device ED may be slimmed as the sealing portion BSL has a width W_{BSL} of about 300 µm or less.

Referring to FIGS. 13 to 17, the sealing portion BSL may fill a space between the housing HAU and the display module DM and a space between the housing HAU and the window WM. The sealing portion BSL may be an adhesive layer that couples the housing HAU and the display module DM to each other and the housing HAU and the window WM to each other.

As the sealing portion BSL is disposed to cover the side surfaces DM-S1, DM-S2, DM-S3, and DM-S4 of the display module DM and the side surfaces WM-S1, WM-S2, WM-S3, and WM-S4 of the window WM, the display device DD may exhibit high durability. In an embodiment, the sealing portion BSL may cover an edge DM-ED of the display module DM and an edge WM-ED of the window WM. The sealing portion BSL may be provided in one process step to cover the edge DM-ED of the display module DM and the edge WM-ED of the window WM. Accordingly, processability may be improved when manufacturing the display device including the sealing portion BSL that covers the edge DM-ED of the display module DM and the edge WM-ED of the window WM. In addition, in an embodiment of the invention, when the edge DM-ED of the display module DM and the edge WM-ED of the window WM are formed to overlap each other in a same process, the coating process of a sealing material for forming the sealing portion BSL covering the matched edges DM-ED and WM-ED may be carried out more easily, and thus processability may be improved when the display device is manufactured.

The sealing portion BSL may cover the edge WM-ED of the window WM, the edge DP-ED of the display panel DP, and the edge LM-ED of the lower module LM disposed below the display panel DP.

Referring to FIGS. 15A and 16, the edge WM-ED of the window WM and the edge DM-ED of the display module DM may overlap each other on at least one side. In an embodiment of the invention, the edge WM-ED of the window WM may overlap the edge DP-ED of the display panel DP and the edge LM-ED of the lower module LM.

Portions in which the edge WM-ED of the window WM and the edge DP-ED of the display panel DP overlap and match each other may correspond to the first to third side surfaces WM-S1, WM-S2, and WM-S3 of the window WM and the first to third side surfaces DM-S1, DM-S2, and DM-S3 of the display module DM.

A portion in which the edge WM-ED of the window WM and the edge DM-ED of the display module DM overlap each other may be formed by batch-cutting at least a portion of the window WM and the display module DM in a same process by a laser cutting method in a method of manufacturing the display device to be described later. That is, in the display device according to an embodiment of the invention, the edges of the first to third side surfaces WM-S1, WM-S2, and WM-S3 of the window WM and the edges of the first to third side surfaces DM-S1, DM-S2, and DM-S3 of the display module DM corresponding thereto may overlap or aligned with each other through batch cutting in a same process. In an embodiment, the batch cutting process may be performed only for the display panel DP and the window WM disposed on the display panel DP.

A display device DD-2 according to an embodiment of the invention illustrated in FIG. 15B is substantially the same as the display device DD according to an embodiment of the invention illustrated in FIG. 15A except for the shape of the sealing portion BSL on a cross section. In the display device DD-2 according to an embodiment of the invention illustrated in FIG. 15B, the edge WM-ED of the window WM and the edge DP-ED of the display panel DP may overlap each other in the third direction DR3, and the edge LM-ED of the lower module may not overlap the edge WM-ED of the window WM and the edge DP-ED of the display panel DP in the third direction DR3. In an embodiment, for example, in the display device DD-2 according to an embodiment of the invention, the edge LM-ED of the lower module may protrude more to the outside than the edge WM-ED of the window WM and the edge DP-ED of the display panel DP in a plan view or when viewed in the third direction DR3. In FIG. 15B, the edge LM-ED of the lower module may correspond to the edge of the support plate MP. In an embodiment, without being limited to what is illustrated, the edges of other members (for example, digitizer module DTM) included in the lower module LM in addition to the edge of the support plate MP may also not overlap the edge WM-ED of the window WM and the edge DP-ED of the display panel DP.

In the display device DD-2 according to an embodiment of the invention, the first to third side surfaces WM-S1, WM-S2, and WM-S3 of the window WM and the first to third side surfaces DM-S1, DM-S2, and DM-S3 of the display panel DP corresponding thereto may be formed through batch cutting such that the edges thereof overlap each other. In such an embodiment, the edge DP-ED of the display panel DP among the display module DM may overlap the edge WM-ED of the window at the first to third side surfaces DM-S1, DM-S2, and DM-S3.

In the display device DD-2 according to an embodiment of the invention, a width W_{BSL-U} of the sealing portion BSL covering the edge WM-ED of the window may be different from a width W_{BSL-D} of the sealing portion BSL covering the lower module LM having an edge which does not match the edge of the window WM. Even when the edges of at least some members of the display module DM do not match the edge WM-ED of the window WM, the sealing portion BSL may be disposed to cover the entire side surface of the display module DM. In addition, the sealing portion BSL may fill a space between the housing HAU and the display module DM in the electronic device ED.

Referring to FIGS. 14 to 15B, a non-display bending portion NDA-BP of the display panel may be located in at least one side portion of the display device DD or DD-2. The non-display bending portion NDA-BP may be bent toward the lower side of the display module DM and disposed to overlap at least a portion of the display panel DP in the third direction DR3. The display devices DD and DD-2 may include a display region DP- DA and a non-display region DP-NDA. The display panel DP of the display device DD may include a display region DP-DA and a non-display region DP-NDA disposed outside the display region DP-DA. Referring to FIG. 4 and the like, the non-display bending portion NDA-BP may be disposed on at least one side of the non-display region DP-NDA.

In an embodiment of the invention illustrated in FIGS. 14 to 15B, the non-display bending portion NDA-BP may be located on the fourth side surface DM-S4 of the display module DM. On the side of the fourth side surface DM-S4, the sealing portion BSL may be disposed to surround the non-display bending portion NDA-BP which is bent toward the lower side of the display module DM and disposed to at least partially overlap the display panel DP.

The display devices DD and DD-2 according to an embodiment of the invention may further include a bending protection layer BPL disposed on the non-display bending portion NDA-BP. The bending protection layer BPL may cover at least a portion of the non-display bending portion NDA-BP. The bending protection layer BPL may protect the non-display bending portion NDA-BP and relieve the bending stress of the non-display bending portion NDA-BP.

The bending protection layer BPL may include an acrylate-based resin, a urethane-based resin, an epoxy-based resin, or the like. In the display devices DD and DD-2 according to an embodiment of the invention, the sealing portion BSL may be located outside the bending protection layer BPL. The sealing portion BSL may cover the bending protection layer BPL. The modulus (e.g., Young's modulus) of the sealing portion BSL may be greater than the modulus of the bending protection layer BPL. Accordingly, the sealing portion BSL may effectively protect the non-display bending portion NDA-BP and the bending protection layer BPL.

The bending protection layer BPL may be disposed both above and below the non-display bending portion NDA-BP. Referring to FIG. 15A, the bending protection layer BPL may include an outer side protection layer BPL-O exposed to the side of the sealing portion BSL and an inner side protection layer BPL-I disposed on the side of the lower module LM and configured to fix the non-display bending portion NDA-BP. In addition, referring to FIG. 15B, the bending protection layer BPL may be disposed to fill the entire space between the display panel DP and the sealing portion BSL and between the lower module LM and the non-display bending portion NDA-BP.

Referring to FIG. 17, in the electronic device ED according to an embodiment of the invention, in a portion in which the non-display bending portion NDA-BP is disposed, the sealing portion BSL may be disposed outside the bending protection layer BPL to fill a space between the housing HAU and the bending protection layer BPL.

Referring to FIGS. 14 to 17, the upper surface of the sealing portion BSL constituting the upper surfaces of the electronic device ED according to an embodiment of the invention and the display devices DD and DD-2 according to an embodiment of the invention may be located at substantially the same height as the upper surface of the window WM. Accordingly, the upper surfaces of the electronic device ED and the display devices DD and DD-2 may be composed of or defined by the upper surface of the window WM and the upper surface of the sealing portion BSL.

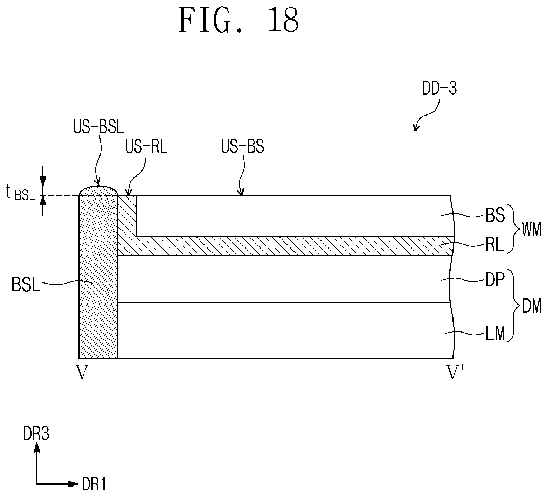

FIG. 18 is a cross-sectional view of a display device according to an embodiment of the invention. FIG. 18 may be a cross-sectional view taken along line V-V' of FIG. 14. A display device DD-3 according to an embodiment of the invention illustrated in FIG. 18 is substantially the same as the display devices DD and DD-2 according to an embodiment of the invention, which are described with reference to FIGS. 14 to 15B except for the shape of the sealing portion BSL.

In the display device DD-3 according to an embodiment of the invention, the sealing portion BSL may have a shape that protrudes upwardly. In an embodiment of the invention, the upper surface US-BSL of the sealing portion may be positioned to protrude more than the base upper surface US-BS and the upper surface US-RL of the resin layer. In FIG. 18, the upper surface US-BSL of the sealing portion is illustrated to protrude outwards and have a convex shape. However, the embodiment of the invention is not limited thereto, and the upper surface US-BSL of the sealing portion may have the shape of a flat surface or a diagonal (or inclined) surface.

A thickness t_{BSL} of the protruding portion of the sealing portion BSL may be about 30 µm or less. In such an embodiment where the upper surface of the sealing portion BSL is formed to protrude, the upper surface of the display device DD-3 may be composed of or defined by the base upper surface US-BS, the upper surface US-RL of the resin layer, and the protruding upper surface US-BSL of the sealing portion.

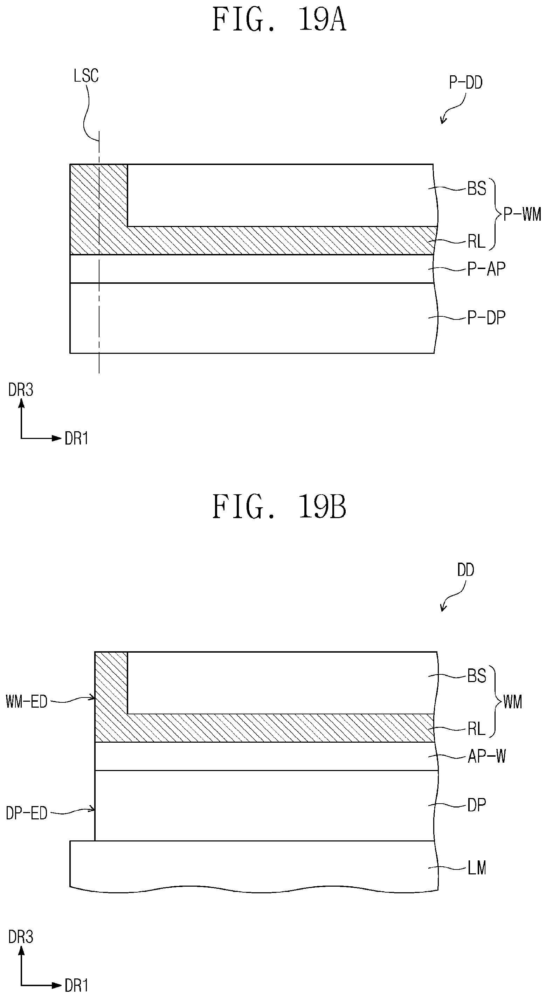

FIGS. 19A to 19C schematically illustrate some of the manufacturing steps of an electronic device according to an embodiment of the invention. FIG. 19A illustrates a process of cutting off a portion of the outer region of a preliminary display device P-DD. The preliminary display device P-DD may include a preliminary display panel P-DP, a preliminary window P-WM, and a preliminary adhesive layer P-AP disposed between the preliminary display panel P-DP and the preliminary window P-WM. In the provided preliminary display device P-DD, a portion of the outer region may be cut off along a laser cutting line LSC. That is, the preliminary display panel P-DP and the preliminary window P-WM may be manufactured to have overlapping edges by being cut all at once by a laser in a stacked state.

FIG. 19B illustrates a manufacturing process of the display device DD according to an embodiment of the invention, to which a lower module LM is attached. The edge WM-ED of the window and the edge DP-ED of the display panel may overlap each other through batch cutting. The lower module LM may be provided below the display panel DP. The lower module LM may be provided after the batch cutting process is performed.

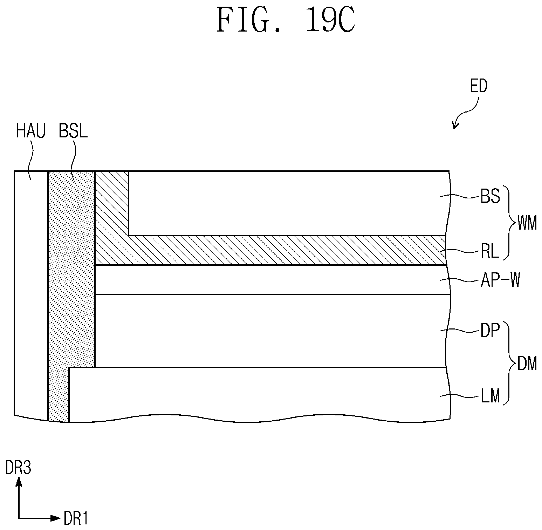

FIG. 19C illustrates a portion of the electronic device ED manufactured according to an embodiment of the invention. After the display module DM is manufactured by providing the lower module LM and the like, the housing HAU that accommodates the window WM and the display module DM may be provided. The sealing portion BSL may fill a space between the housing HAU and the window WM and a space between the housing HAU and the display module DM.

In the electronic device ED manufactured by the manufacturing method described as an example by using the processes of FIGS. 19A to 19C, the edge of the lower module LM may be protruding outwards without overlapping the edge of the display panel DP, but the embodiment of the invention is not limited thereto.

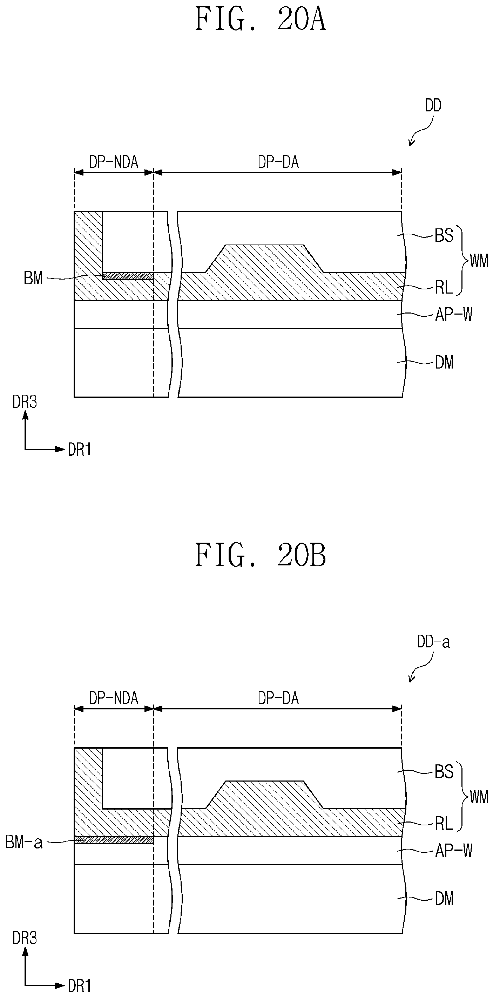

Each of FIGS. 20A to 20C is a cross-sectional view of a partial region of a display device according to an embodiment of the invention. Referring to FIGS. 20A to 20C, display devices DD, DD-a, and DD-b according to an embodiment of the invention may respectively further include printed layers BM, BM-a, and BM-b overlapping the non-display region DP-NDA.

The printed layers BM, BM-a, and BM-b may effectively prevent some components disposed in the non-display region DP-NDA from being viewed from the outside and also effectively prevent a light leakage phenomenon and the like. Accordingly, the printed layers BM, BM-a, and BM-b may have lower transmittance than the window WM. In an embodiment, for example, the printed layers BM, BM-a, and BM-b may include a black coloring agent. The printed layers BM, BM-a, and BM-b may have an optical density of about 4 or greater. However, the embodiment of the invention is not limited thereto, and anything that can block lower components in the non-display region DP-NDA from being viewed from the outside may be used without limitation.

Referring to FIG. 20A, in the display device DD according to an embodiment of the invention, the printed layer BM may be disposed between the base glass BS and the resin layer RL. The printed layer BM may be directly disposed between the base glass BS and the resin layer RL. The printed layer BM may be disposed on the lower surface of the base glass BS to correspond to the non-display region DP-NDA.

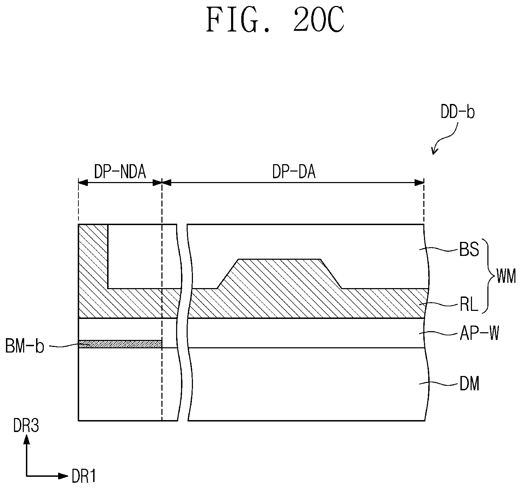

Referring to FIGS. 20B and 20C, the printing layers BM-a and BM-b may be disposed between the window WM and the display module DM. In the display device DD-a according to an embodiment of the invention, the printed layer BM-a may be disposed directly on the lower surface of the resin layer RL. In addition, in the display device DD-b according to an embodiment of the invention, the printing layer BM-b may be disposed directly on the upper surface of the display module DM.

FIGS. 20A to 20C illustrate embodiments where the printed layers BM, BM-a, and BM-b are provided as a single layer on any one layer, but the embodiment of the invention is not limited thereto, and the printed layers BM, BM-a, and BM-b may be provided as a plurality of layers, or the display devices DD, DD-a, and DD-b may include a plurality of printed layers BM, BM-a, and BM-b disposed in different layers.

It would be understood that the structure of the window and the display device described with reference to FIGS. 4 to 20C may also be applied to the electronic device having the folding operation characteristics of FIGS. 2A to 3C. By including the window including a base glass and a resin layer and the sealing portion surrounding the outside of the window and the display module, the electronic devices ED-a and ED-b according to an embodiment of the invention may exhibit high durability and surface display quality and good folding characteristics.

The window according to an embodiment of the invention may exhibit high durability by including a base glass and a resin layer covering any one of the upper and lower surfaces and a side surface of the base glass. In addition, as the window according to an embodiment of the invention includes a folding portion including a groove portion defined on one surface and non-folding portions disposed to be spaced apart from each other with the folding portion interposed therebetween, and as the non-folding portion includes a base glass having a sufficient thickness of about 70 µm or greater and a resin layer covering the lower surface and side surface of the base glass and having a maximum thickness of about 30 µm or greater in a portion corresponding to the folding portion, the window may exhibit high durability and impact resistance, good folding characteristics, and high exterior quality.

By including the window according to the embodiment of the invention described above, the display device according to an embodiment of the invention may exhibit high durability even when a separate cover member or protective film is excluded (not provided) on the window, and the overall thickness of the display device may also be reduced. In addition, since an additional member such as a cover member or protective film may be excluded, processability may be improved and costs may be reduced when the display device is manufactured.

As the electronic device according to an embodiment of the invention includes the window according to the embodiment of the invention described above and the sealing portion disposed between the housing and the display module and between the housing and the window, a separate cover member, a protective film, and a deco layer surrounding and dividing the display portion may be excluded. Even when these additional members are excluded, the electronic device according to an embodiment of the invention may exhibit high durability and surface display quality, and the overall thickness may be reduced to make the electronic device slim.

By including the window including a base glass and a resin layer covering one surface and a side surface of the base glass, the display device according to an embodiment of the invention may exhibit high durability and high exterior quality even when an additional protection member is omitted on the window.

By including the window, which includes a base glass and a resin layer covering one surface and a side surface of the base glass, as an uppermost member and the sealing portion surrounding the outer edge of the window and the outer edge of the display module disposed below the window, the display device and the electronic device according to an embodiment of the invention may exhibit the characteristics of being slim while having high impact strength and high durability.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display device (DD) comprising:
a display module (DM) comprising a folding display portion (FP-D), which is transformed into a folded or non-folded state, and a non-folding display portion (NFP1-D, NFP2-D) adjacent to the folding display portion (FP-D); and
a window (WM) including an upper surface (US-WM) of the window (WM) which is a flat surface and is spaced apart from the display module (DM), and a lower surface (DS-WM) which is a flat surface, faces the upper surface (US-WM) of the window (WM), and is adjacent to the display module (DM),
wherein the window (WM) comprises:
a base glass (BS) comprising a base upper surface (US-BS) which is a flat surface and is spaced apart from the display module (DM), a base lower surface (DS-BS) facing the base upper surface (US-BS) and having a groove portion (HP) defined therein to correspond to the folding display portion (FP-D), and a base side surface (SS-BS) disposed between the base upper surface (US-BS) and the base lower surface (DS-BS); and
a resin layer (RL) comprising a folding resin portion (RL-FP) disposed below the base glass (BS) to correspond to the folding display portion (FP-D), a non-folding resin portion (RL-NFP1, RL-NFP2) disposed below the base glass (BS) to correspond to the non-folding display portion (NFP1-D, NFP2-D), and a side resin portion (RL-SP) covering at least a portion of the base side surface (SS-BS),
wherein
a thickness (t_{WNF}) of a portion of the base glass (BS) overlapping the non-folding display portion (NFP1-D, NFP2-D) is about 70 µm or greater,
a maximum thickness (t_{RF}) of the folding resin portion (RL-FP) is about 30 µm or greater, and
a width (W_{RL}) of the side resin portion (RL-SP) in a plan view is in a range of about 50 µm to about 300 µm.

2. The display device (DD) of claim 1, wherein the thickness (t_{WNF}) of the portion of the base glass (BS) overlapping the non-folding display portion (NFP1-D, NFP2-D) is in a range of about 150 *µ* m to about 300 *µ* m.

3. The display device (DD) of claim 1 or 2, wherein the maximum thickness (t_{RF}) of the folding resin portion (RL-FP) is in a range of about 100 µm to about 300 µm.

4. The display device (DD) of at least one of claims 1 to 3, wherein a thickness (t_{TM}) from a lowermost surface of the display module (DM) to the upper surface (US-WM) of the window (WM) is about 700 µm or less.

5. The display device (DD) of at least one of claims 1 to 4, wherein the display module (DM) comprises a display panel (DP) and a support plate (MP) disposed below the display panel (DP).

6. The display device (DD) of at least one of claims 1 to 5, wherein the base glass (BS) is divided into a folding portion (BS-MP) including the groove portion (HP), and a first non-folding portion (BS-NFP1) and a second non-folding portion (BS-NFP2) spaced apart from each other with the folding portion (BS-MP) interposed therebetween,
wherein the folding portion (BS-MP) has a thickness (t_{WF}) in a range of about 30 *µ* m to about 80 *µ* m.

7. The display device (DD) of at least one of claims 1 to 6, wherein the upper surface (US-WM) of the window (WM) is an uppermost surface of the display device (DD).

8. The display device (DD) of at least one of claims 1 to 7, wherein the upper surface (US-WM) of the window (WM) is defined by the base upper surface (US-BS) and an upper surface (US-RL) of the side resin portion (RL-SP).

9. The display device (DD) of at least one of claims 1 to 7, wherein the window (WM) further comprises a functional layer (FCL) disposed on the base glass (BS),
wherein the functional layer (FCL) comprises:
a reflection reduction layer (AR) having a reflectance of about 2% or less at a wavelength of about 550 nm; and
an anti-fingerprint layer (AF) disposed on the reflection reduction layer (AR) and having a water contact angle of about 100 degrees or greater,
wherein an upper surface of the functional layer (FCL) is an uppermost surface of the display device (DD).

10. The display device (DD) of claim 9, wherein
a thickness (W_{AR}) of the reflection reduction layer (AR) is in a range of about 50 nm to about 1000 nm,
a thickness (W_{AF}) of the anti-fingerprint layer (AF) is in a range of about 5 nm to about 50 nm, and
a thickness (t_{TM}) from a lowermost surface of the display module (DM) to an upper surface of the anti-fingerprint layer (AF) is about 700 µm or less.

11. The display device (DD) of claim 9 or 10, wherein
the functional layer (FCL) overlaps the base glass (BS) and the side resin portion (RL-SP), and
the functional layer (FCL) is disposed directly on the base upper surface (US-BS) and an upper surface (US-RL) of the side resin portion (RL-SP).

12. The display device (DD) of at least one of claims 1 to 11, wherein the resin layer (RL) comprises a urethane-based resin and a silane-based additive.

13. The display device (DD) of at least one of claims 1 to 12, wherein the resin layer (RL) has a modulus of about 50 MPa or greater at 25°C, a modulus of about 1000 MPa or less at -20°C, and a modulus of about 500 MPa or less at 60°C.

14. The display device (DD) of at least one of claims 1 to 13, wherein the display module (DM) comprises a display region (DP-DA) and a non-display region (DP-NDA) surrounding the display region (DP-DA) and further comprises a printed layer (BM) overlapping the non-display region (DP-NDA),
wherein the printed layer (BM) is disposed directly between the base glass (BS) and the resin layer (RL), directly on the lower surface (DS-WM) of the resin layer (RL) between the window (WM) and the display module (DM), or directly on an upper surface of the display module (DM) between the window (WM) and the display module (DM).

15. An electronic device (ED), especially with a display device (DD) according to at least one of claims 1 to 14, comprising:
a display module (DM) divided into a folding display portion (FD-D), which is transformed into a folded or non-folded state, and a non-folding display portion (NFP1-D, NFP2-D) adjacent to the folding display portion (FD-D), wherein the display module (DM) comprises a display panel (DP) and a support plate (MP) disposed below the display panel (DP);
a window (WM) disposed on the display module (DM) and comprising a base glass (BS) and a resin layer (RL) overlapping an entire portion of the base glass (BS);
a housing (HAU) accommodating the display module (DM) and the window (WM); and
a sealing portion (BSL) which fills a space between the housing (HAU) and an edge of the display module (DM) and a space between the housing (HAU) and an edge of the window (WM),
wherein
the base glass (BS) comprises a base upper surface (US-BS) which is spaced apart from the display module (DM) and is a flat surface, a base lower surface (DS-BS) having a concave groove portion (HP) defined therein in a direction toward the base upper surface (US-BS) to correspond to the folding display portion (FD-D), and a base side surface (SS-BS) connecting the base upper surface (US-BS) and the base lower surface (DS-BS) to each other,
the resin layer (RL) fills the groove portion (HP) and covers the base lower surface (DS-BS) and the base side surface (SS-BS), and
the sealing portion (BSL) is disposed directly on a side surface of the resin layer (RL).

16. The electronic device (ED) of claim 15, wherein, in a plan view, the sealing portion (BSL) has a shape surrounding an entire exterior of the window (WM).

17. The electronic device (ED) of claim 15 or 16, wherein, in a plan view, a width (W_{BSL}) of the sealing portion (BSL) is about 100 *µ* m to about 300 *µ* m.

18. The electronic device (ED) of at least one of claims 15 to 17, wherein the sealing portion (BSL) is an adhesive layer which couples the housing (HAU) and the display module (DM) to each other and the housing (HAU) and the window (WM) to each other.

19. The electronic device (ED) of at least one of claims 15 to 18, wherein an upper surface of the electronic device (ED) is defined by the base upper surface (US-BS), an upper surface (US-RL) of the resin layer (RL) covering the base side surface (SS-BS), and an upper surface (US-BSL) of the sealing portion (BSL) surrounding the resin layer (RL).

20. The electronic device (ED) of at least one of claims 15 to 19, wherein
an upper surface (US-BSL) of the sealing portion (BSL) protrudes more outwardly than the base upper surface (US-BS) and the upper surface (US-RL) of the resin layer (RL) in a plan view, and
a thickness (t_{BSL}) of a protruding portion of the sealing portion (BSL) is about 30 µm or less.

21. The electronic device (ED) of at least one of claims 15 to 18, wherein the window (WM) further comprises a functional layer (FCL) disposed to overlap the base upper surface (US-BS) and the upper surface (US-RL) of the resin layer (RL),
wherein the functional layer (FCL) comprises at least one selected from a reflection reduction layer (AR) or an anti-fingerprint layer (AF).

22. The electronic device (ED) of at least one of claims 15 to 21, wherein the display module (DM) comprises:
a display region (DP-DA);
a non-display region (DP-NDA) surrounding the outside of the display region (DP-DA);
a non-display bending portion (NDA-BP) disposed at one side of the non-display region (DP-NDA) and bent toward the lower side of the display module (DM); and
a bending protection layer (BPL) disposed on the non-display bending portion (NDA-BP),
wherein the sealing portion (BSL) covers the bending protection layer (BPL).

23. The electronic device (ED) of at least one of claims 1 to 22, wherein the resin layer (RL) comprises a urethane-based resin and a silane-based additive.
